(19) **Europäisches Patentamt**
**European Patent Office**
**Office européen des brevets**

(11) **EP 4 603 792 A1**

(12) **EUROPEAN PATENT APPLICATION**
published in accordance with Art. 153(4) EPC

(43) Date of publication:
**20.08.2025 Bulletin 2025/34**

(21) Application number: **23916119.3**

(22) Date of filing: **24.10.2023**

(51) International Patent Classification (IPC):
**G01B 11/06** (2006.01)

(52) Cooperative Patent Classification (CPC):
**G01B 11/06**

(86) International application number:
**PCT/JP2023/038333**

(87) International publication number:
**WO 2024/150501 (18.07.2024 Gazette 2024/29)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **10.01.2023 JP 2023001846**

(71) Applicant: **Hamamatsu Photonics K.K.**
**Hamamatsu-shi, Shizuoka 435-8558 (JP)**

(72) Inventors:
• **OHTSUKA Kenichi**
**Hamamatsu-shi, Shizuoka 435-8558 (JP)**
• **MORISHIMA Kota**
**Hamamatsu-shi, Shizuoka 435-8558 (JP)**
• **TSUCHIYA Kunihiko**
**Hamamatsu-shi, Shizuoka 435-8558 (JP)**
• **TAKAHASHI Teruo**
**Hamamatsu-shi, Shizuoka 435-8558 (JP)**

(74) Representative: **Grünecker Patent- und**
**Rechtsanwälte**
**PartG mbB**
**Leopoldstraße 4**
**80802 München (DE)**

(54) **FILM THICKNESS MEASURING DEVICE AND FILM THICKNESS MEASURING METHOD**

(57) A film thickness measuring apparatus includes a light irradiation unit, an inclined dichroic mirror, an area sensor, and an analysis unit that derives a first wavelength centroid based on a first signal and derives a second wavelength centroid based on a second signal. The analysis unit derives at least one first film thickness candidate based on the relationship information between a film thickness and a wavelength centroid of a sample at a first wavelength, and the first wavelength centroid, derives at least one second film thickness candidate based on the relationship information between the film thickness and the wavelength centroid of the sample at a second wavelength, and the second wavelength centroid, and derives the film thickness of the sample based on the first film thickness candidate and the second film thickness candidate.

*Fig.1*

EP 4 603 792 A1

## Description

## Technical Field

One aspect of the present disclosure relates to a film thickness measuring apparatus and a film thickness measuring method.

## Background Art

Patent Literature 1 discloses a technique of using a dichroic mirror, whose transmittance and reflectance change according to a wavelength, to separate light from an object, obtaining a wavelength centroid by imaging each of the light separated, and estimating a film thickness of the object based on the wavelength centroid.

## Citation List

## Patent Literature

Patent Literature 1: WO 2021/161986 A

## Summary of Invention

## Technical Problem

In the film thickness measuring method using the wavelength centroid described above, the relationship between the film thickness and the wavelength centroid is perceived in advance, and the film thickness of the object is estimated from the value of the wavelength centroid. Here, depending on the type of film to be measured and the wavelength of light to be irradiated, a plurality of film thickness candidates can be given from the value of the wavelength centroid. In this case, the film thickness cannot be uniquely estimated, which possibly reduces the accuracy of measuring the film thickness.
An aspect of the present disclosure has been made in view of the above circumstances, and relates to a film thickness measuring apparatus and a film thickness measuring method capable of measuring a film thickness of an object with high accuracy.

## Solution to Problem

A film thickness measuring apparatus according to an aspect of the present disclosure is a film thickness measuring apparatus for measuring a film thickness of an object having a film formed on a substrate, the film thickness measuring apparatus including a light irradiation unit configured to irradiate the object with each of first light having a first wavelength and second light having a second wavelength different from the first wavelength; an optical element having transmittance and reflectance changing according to a wavelength in a predetermined wavelength range, the optical element configured to transmit and reflect the first light and the second light from the object to separate the first light and the second light; a light detection unit configured to detect the first light that has been reflected by the optical element and the first light that has passed through the optical element to output a first signal, and configured to detect the second light that has been reflected by the optical element and the second light that has passed through the optical element to output a second signal; and an analysis unit configured to derive a first wavelength centroid based on the first signal and derive a second wavelength centroid based on the second signal, in which the analysis unit includes deriving at least one first film thickness candidate based on relationship information between the film thickness and a wavelength centroid of the object at the first wavelength, and the first wavelength centroid, deriving at least one second film thickness candidate based on relationship information between the film thickness and a wavelength centroid of the object at the second wavelength, and the second wavelength centroid, and deriving the film thickness of the object based on the first film thickness candidate and the second film thickness candidate.
In the film thickness measuring apparatus according to an aspect of the present disclosure, the object is irradiated with the first light having the first wavelength, the first light from the object which has been reflected by the optical element and the first light that has passed through the optical element are detected and the first signal is output, and the first wavelength centroid is derived based on the first signal. Then, at least one first film thickness candidate is derived based on the relationship information between the film thickness and the wavelength centroid of the object at the predetermined first wavelength, and the derived first wavelength centroid. Further, in the film thickness measuring apparatus according to an aspect of the present disclosure, the object is irradiated with the second light having the second wavelength, the second light from the object which has been reflected by the optical element and the second light that has passed through the optical element are detected and the second signal is output, and the second wavelength centroid is derived based on the second signal. Then, at least one second film thickness candidate is derived based on the relationship information between the film thickness and the wavelength centroid of the object at the predetermined second wavelength, and the derived second wavelength centroid. Further, in the film thickness measuring apparatus according to an aspect of the present disclosure, the film thickness of the object is derived based on the first film thickness candidate and the second film thickness candidate described above.

As described above, in the film thickness measuring apparatus according to an aspect of the present disclosure, one or a plurality of film thickness candidates is derived based on light of a plurality of wavelengths different from each other. For example, in a case where the film thickness is to be derived based on the relationship information between the film thickness and the wavelength centroid of the object at a certain type of wavelength and on the derived wavelength centroid, there is a plurality of candidates for the film thickness corresponding to the derived wavelength centroid, which makes it impossible to uniquely identify the film thickness in some cases. In addition, depending on the shape of the waveform indicating the relationship information between the film thickness and the wavelength centroid, the extreme values of the waveform are smoothed, the difference in film thickness due to the difference in the wavelength centroid is less noticeable, and the film thickness corresponding to the wavelength centroid cannot be accurately derived in some cases. In this regard, as described above, one or a plurality of film thickness candidates is derived based on light of a plurality of wavelengths different from each other and, thus, even in a case where the film thickness cannot be uniquely determined with light of one wavelength, the film thickness of the object can be appropriately derived based on the film thickness candidates by taking into account of consistency or the like of the film thickness candidates for each of the light of a plurality of wavelengths. In addition, as for the light of a plurality of wavelengths different from each other, extreme values (range in which the film thickness cannot be accurately derived) of the waveform indicating the relationship information between the film thickness and the wavelength centroid are not consistent with each other, and thus the film thickness of the object can be appropriately derived based on each of the film thickness candidates. As described above, according to the film thickness measuring apparatus of an aspect of the present disclosure, the film thickness of the object can be measured with high accuracy.

In the film thickness measuring apparatus, the light irradiation unit further irradiates the object with third light having a third wavelength different from the first wavelength and the second wavelength, the optical element transmits and reflects the third light from the object to further separate the third light, the light detection unit further detects the third light that has been reflected by the optical element and the third light that has passed through the optical element to output a third signal, the analysis unit further derives a third wavelength centroid based on the third signal, and further derives at least one third film thickness candidate based on relationship information between the film thickness and a wavelength centroid of the object at the third wavelength, and the third wavelength centroid, and may derive the film thickness of the object based on the first film thickness candidate, the second film thickness candidate, and the third film thickness candidate. In this way, one or a plurality of film thickness candidates is derived based on light of three types of wavelengths different from each other, which makes it easier to identify the film thickness uniquely as compared with the case of using light of two types of wavelengths. As a result, the film thickness of the object can be measured with higher accuracy.

In the film thickness measuring apparatus, the analysis unit may set, in advance, an expected film thickness range from a designed film thickness value, and derive the first film thickness candidate and the second film thickness candidate only from within the expected film thickness range. In a case where the expected film thickness range is assumed in advance, the processing time related to the film thickness derivation can be shortened by deriving the film thickness candidate only from within the expected film thickness range.

In the film thickness measuring apparatus, the light irradiation unit includes a light source configured to emit monochromatic light of three or more wavelengths, and may irradiate the object with the first light configured by simultaneously emitting monochromatic light of two wavelengths among the monochromatic light of three or more wavelengths. In the waveform indicating the relationship information between the film thickness and the wavelength centroid, the wider the wavelength width of light, the steeper the slope of the curve, and the narrower the wavelength width of light, the gentler the slope of the curve. The steeper the slope of the waveform curve, the greater the change in film thickness with respect to the change in wavelength centroid and, thus, the film thickness can be accurately derived. Therefore, by simultaneously emitting the monochromatic light of two wavelengths and widening the wavelength width of the first light, the curve in the waveform indicating the relationship information between the film thickness and the wavelength centroid can be steepened, and the film thickness of the object can be measured with higher accuracy.

In the film thickness measuring apparatus, the monochromatic light of two wavelengths may be light of a red wavelength and light of a blue wavelength. As described above, the monochromatic light of two wavelengths is the light of the red wavelength and the light of the blue wavelength having a large difference in wavelength, so that the wavelength width of the first light is increased, and the film thickness of the object can be measured with higher accuracy.

A film thickness measuring method according to an aspect of the present disclosure is a film thickness measuring method executed by a film thickness measuring apparatus for measuring a film thickness of an object having a film formed on a substrate, the film thickness measuring method including a first irradiation step of irradiating the object with first light having a first wavelength; a first separation step of using an optical element having transmittance and reflectance changing according to a wavelength in a predetermined wavelength range to transmit and reflect the first light from the object; a first light detection step of detecting the first light that has been reflected by the optical element and the first light that has passed through the optical element to output a first signal; a first calculation step of deriving a first wavelength centroid based on the first signal and deriving at least one first film thickness candidate based on relationship information between the film thickness and a wavelength centroid of the object at the first wavelength, and the first wavelength centroid; a second irradiation step of irradiating the object with second light having a second wavelength different from the first wavelength; a second separation step of using the optical element to transmit and reflect the second light from the object; a second light detection step of detecting the second light that has been reflected by the optical element and the second light that has passed through the optical element to output a second signal; a second calculation step of deriving a second wavelength centroid based on the second signal and deriving at least one second film thickness candidate based on relationship information between the film thickness and a wavelength centroid of the object at the second wavelength, and the second wavelength centroid; and an analysis step of deriving the film thickness of the object based on said at least one first film thickness candidate determined in the first calculation step and said at least one second film thickness candidate determined in the second calculation step.

The film thickness measuring method further includes a third irradiation step of further irradiating the object with third light having a third wavelength different from the first wavelength and the second wavelength, a third separation step of transmitting and reflecting the third light from the object to further separate the third light, a third light detection step of further detecting the third light that has been reflected by the optical element and the third light that has passed through the optical element to output a third signal, and a third calculation step of further deriving a third wavelength centroid based on the third signal, and further deriving at least one third film thickness candidate based on relationship information between the film thickness and a wavelength centroid of the object at the third wavelength, and the third wavelength centroid, in which, in the analysis step, the film thickness of the object may be derived based on the first film thickness candidate, the second film thickness candidate, and the third film thickness candidate.

In the film thickness measuring method, in which, in the analysis step, an expected film thickness range is set, in advance, from a designed film thickness value, and the first film thickness candidate and the second film thickness candidate may be derived only from within the expected film thickness range.

In the film thickness measuring method, in which, in the first irradiation step, the object may be irradiated with the first light configured by simultaneously emitting monochromatic light of two wavelengths among monochromatic light of three or more wavelengths emitted from a light source configured to emit the monochromatic light of three or more wavelengths.

In the film thickness measuring method, the monochromatic light of two wavelengths may be light of a red wavelength and light of a blue wavelength.

## Advantageous Effects of Invention

According to one aspect of the present disclosure, the film thickness of the object can be measured with high accuracy.

## Brief Description of Drawings

FIG. 1 is a diagram schematically illustrating a film thickness measuring apparatus according to the present embodiment.

FIG. 2 is a diagram schematically illustrating a configuration for a case where a multicolor LED array is used as a configuration of a light irradiation unit.

FIG. 3 is a diagram schematically illustrating a configuration for a case where a white light source and a filter switching mechanism are used as a configuration of a light irradiation unit.

FIG. 4 is a diagram illustrating a relationship between a characteristic of a dichroic mirror and a wavelength of light emitted from a light source.

FIG. 5 is a diagram for explaining a spectrum of light and a characteristic of an inclined dichroic mirror.

FIG. 6 is a diagram for explaining a wavelength shift according to the amount of transmitted light and the amount of reflected light.

FIG. 7 is a diagram illustrating reflectance according to a wavelength for each film thickness.

FIG. 8 illustrates a waveform indicating relationship information between a film thickness and a wavelength centroid of a sample.

FIG. 9 illustrates a waveform indicating relationship information between a film thickness and a wavelength centroid of a sample for each of a plurality of types of wavelengths.

FIG. 10(a) is a diagram illustrating a system spectral characteristic according to a wavelength for each combination of monochromatic light in the configuration illustrated in FIG. 2. FIG. 10(b) is a diagram illustrating a relationship between a wavelength centroid and a film thickness in the configuration illustrated in FIG. 2.

FIG. 11(a) is a diagram illustrating a system spectral characteristic according to a wavelength for each setting filter in the configuration illustrated in FIG. 3. FIG. 11(b) is a diagram illustrating a relationship between a wavelength centroid and a film thickness in the configuration illustrated in FIG. 3.

FIG. 12 is a flowchart illustrating a specific process of film thickness measurement.

FIGS. 13(a) to 13(c) are diagrams for explaining film thickness search block settings for each of three wavelength patterns different from each other.

FIG. 14 is a diagram for explaining derivation of film thickness candidates.

FIG. 15 is a diagram for explaining derivation of film thickness candidates according to an expected film thickness range.

FIG. 16 is a diagram for explaining derivation of film thickness candidates for each wavelength pattern.

FIG. 17 is a diagram illustrating derived film thickness candidates.

FIG. 18 is a diagram for explaining derivation of film thickness based on selection of an optimum combination of film thickness candidates.

FIG. 19(a) is a diagram for explaining derivation of film thickness in a sample having large film thickness unevenness. FIG. 19(b) is an example of correct data of film thickness. FIG. 19(c) is a diagram illustrating a multi-wavelength analysis result corresponding to the correct data illustrated in FIG. 19(b).

FIG. 20(a) is a diagram illustrating a relationship between a wavelength centroid and a film thickness for a case where light having a relatively narrow wavelength range is used. FIG. 20(b) is a diagram illustrating a relationship between a wavelength centroid and a film thickness for a case where light having a relatively wide wavelength range is used. FIG. 20(c) is a diagram illustrating a relationship between a wavelength centroid and a film thickness for a case where light having a relatively wide wavelength range and a plurality of peaks (two maximum values) is used.

FIG. 21(a) is a diagram illustrating a result of film thickness mapping for a case where light of a red wavelength and light of a blue wavelength are used. FIG. 21(b) is a diagram illustrating a result of film thickness mapping for a case where light of a green wavelength and light of a blue wavelength are used. FIG. 21(c) is a diagram illustrating a result of film thickness mapping for a case where light of a red wavelength and light of a green wavelength are used. FIG. 21(d) is a diagram illustrating correct data of a result of film thickness mapping.

**Description of Embodiments**

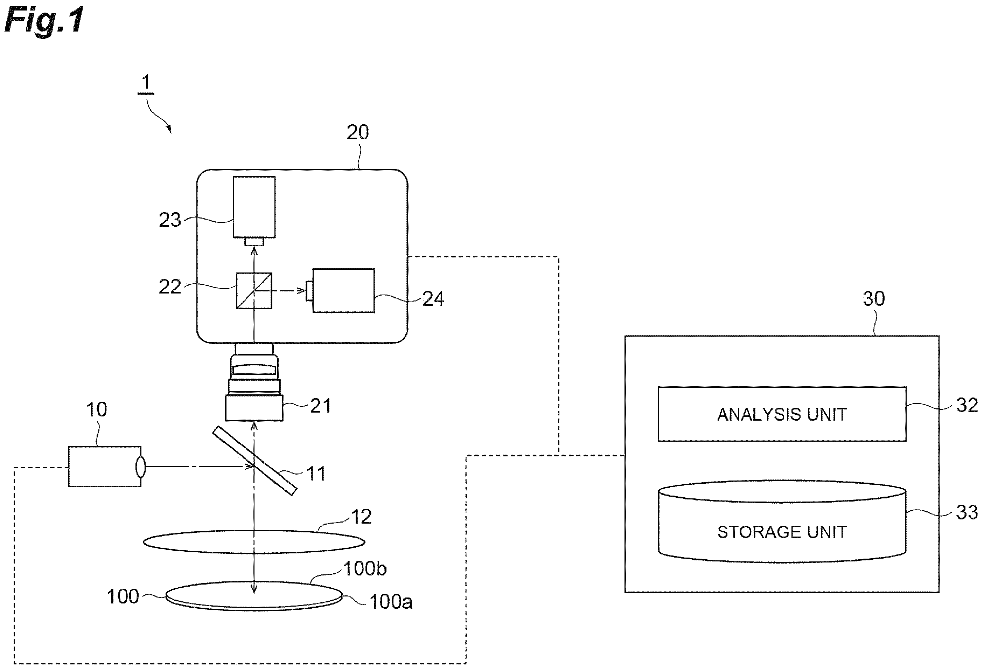

FIG. 1 is a diagram schematically illustrating a film thickness measuring apparatus 1 according to the present embodiment. The film thickness measuring apparatus 1 is an apparatus that irradiates a sample 100 (object) with light in a planar manner and measures a thickness of a film formed on the sample 100 based on light reflected from the sample 100. The sample 100 may be, for example, a light emitting element such as an LED, a mini LED, a μLED, an SLD element, a laser element, a vertical laser element (VCSEL), or an OLED, or may be a light emitting element that adjusts a light emission wavelength by a fluorescent substance including a nano dot or the like. Examples of the sample 100 include an optical film, a thin film for a display panel, and a thin film for a semiconductor. The sample 100 is an object in which a film 100b is formed on a surface of a substrate 100a. In the present embodiment, the sample 100 will be described on the assumption that only one layer of the film 100b is formed on the surface of the substrate 100a. The film 100b is, for example, an oxide film, a nitride film, or the like, but may be another film.

As illustrated in FIG. 1, the film thickness measuring apparatus 1 includes a light irradiation unit 10, a half mirror 11, a field lens 12, a camera system 20, and a control apparatus 30 (analysis unit 32, storage unit 33).

The light irradiation unit 10 irradiates the sample 100 with light in a planar manner. For example, the light irradiation unit 10 irradiates substantially the entire surface of the sample 100 with light in a planar manner. The light irradiation unit 10 includes, for example, a light source capable of uniformly applying light to the surface of the sample 100, and may irradiate the sample 100 with diffused light.

The light irradiation unit 10 irradiates the sample 100 with first light having a first wavelength and second light having a second wavelength different from the first wavelength. Further, the light irradiation unit 10 may irradiate the sample 100 with third light having a third wavelength different from the first wavelength and the second wavelength. Note that each of the first wavelength, the second wavelength, and the third wavelength may have a wavelength range (wavelength width). The phrase that the wavelengths are "different" may include a case where the wavelength ranges partly overlap. To be specific, "the second wavelength different from the first wavelength" includes not only a wavelength having a wavelength range completely different from that of the first wavelength but also a wavelength having a wavelength range partially overlapping with that of the first wavelength but not completely matching that of the first wavelength. Similarly, "the third wavelength different from the first wavelength and the second wavelength" includes not only a wavelength having a wavelength range completely different from that of each of the first wavelength and the second wavelength but also a wavelength having a wavelength range partially overlapping with that of the first wavelength or the second wavelength but not completely matching that of the first wavelength or the second wavelength. In the following description, it is assumed that the light irradiation unit 10 irradiates the sample 100 with the first light, the second light, and the third light. The light emitted from the light irradiation unit 10 passes through the half mirror 11 and the field lens 12 to be applied to the sample 100 in a planar manner.

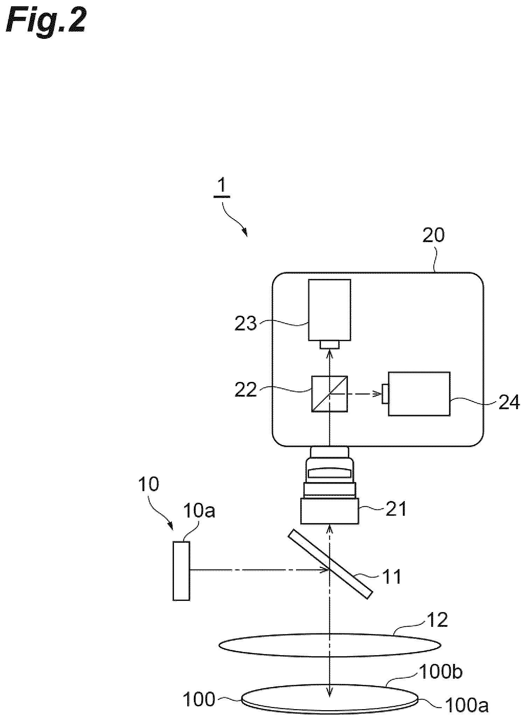

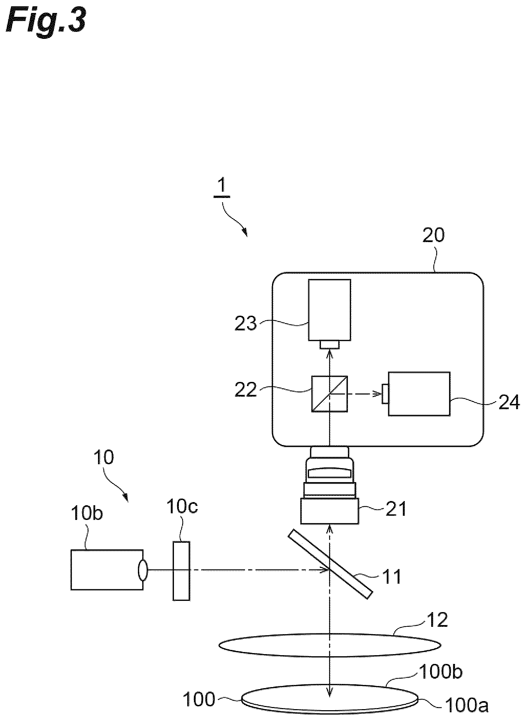

An example of a detailed configuration of the light irradiation unit 10 will be described with reference to FIGS. 2 and 3. FIG. 2 is a diagram schematically illustrating a configuration for a case where a multicolor light emitting diode (LED) array light source 10a is used as the configuration of the light irradiation unit 10. The light irradiation unit 10 includes the multicolor LED array light source 10a that is a light source capable of emitting monochromatic light of three or more wavelengths. The monochromatic light herein means light having a narrow wavelength width. The light having a narrow wavelength width is, for example, light having a full width at half maximum of a spectrum of less than 100 nm. Conversely, the light having a wide wavelength width is, for example, light having a full width at half maximum of a spectrum of 100 nm or more. In the light irradiation unit 10 having such a configuration, the multicolor LED array light source 10a may irradiate the sample 100 with the first light configured by simultaneously emitting monochromatic light of two wavelengths among the monochromatic light of three or more wavelengths. In this case, the multicolor LED array light source 10a irradiates the sample 100 with the second light configured by simultaneously emitting monochromatic light of two wavelengths of a combination different from that of the first light. In addition, the multicolor LED array light source 10a irradiates the sample 100 with the third light configured by simultaneously emitting monochromatic light of two wavelengths of a combination different from that of each of the first light and the second light.

That is, for example, in a case where the multicolor LED array light source 10a can emit monochromatic light of a red wavelength, monochromatic light of a green wavelength, and monochromatic light of a blue wavelength, the monochromatic light of two wavelengths may be monochromatic light of a red wavelength and monochromatic light of a blue wavelength, monochromatic light of a red wavelength and monochromatic light of a green wavelength, or monochromatic light of a green wavelength and monochromatic light of a blue wavelength. In this case, the first light may be light configured by simultaneously emitting monochromatic light of a red wavelength and monochromatic light of a blue wavelength. Further, the second light may be light configured by simultaneously emitting monochromatic light of a red wavelength and monochromatic light of a green wavelength. Furthermore, the third light may be light configured by simultaneously emitting monochromatic light of a green wavelength and monochromatic light of a blue wavelength. Note that the first light, the second light, and the third light each are not necessarily light configured by simultaneously emitting monochromatic light of two wavelengths. The monochromatic light of a red wavelength is light with a wavelength of 610 nm or more and 780 nm or less, the monochromatic light of a green wavelength is light with a wavelength of 500 nm or more and 570 nm or less, and the monochromatic light of a blue wavelength is light with a wavelength of 430 nm or more and 490 nm or less.

The multicolor LED array light source 10a as described above can generate light of various wavelength patterns by combining the LEDs. Since the multicolor LED array light source 10a is configured with LEDs, it has a long lifetime. In addition, the multicolor LED array light source 10a is not so configured that a filter sets the wavelength and, thus, a filter switching mechanism (movable unit) or the like for changing filters is unnecessary. This allows the wavelength to be quickly switched with a simple configuration. Incidentally, the light irradiation unit 10 may use a wavelength-tunable light source (not illustrated) as a configuration in which no filter switching mechanism is provided similarly to the multicolor LED array light source 10a.

FIG. 3 is a diagram schematically illustrating a configuration for a case where a white light source 10b and a filter switching mechanism 10c are used as the configuration of the light irradiation unit 10. In the light irradiation unit 10 illustrated in FIG. 3, light emitted from the white light source 10b passes through a filter set by the filter switching mechanism 10c and is applied to the sample 100. In this case, the light irradiation unit 10 irradiates the sample 100 with the first light, the second light, and the third light described above by switching the filters with the filter switching mechanism 10c.

The light irradiation unit 10 irradiates the sample 100 with light having a wavelength included in a predetermined wavelength range of an inclined dichroic mirror 22 (detailed later) included in the camera system 20. Although details will be described later, the inclined dichroic mirror 22 is an optical element that separates the light from the sample 100 by transmitting and reflecting the light according to the wavelength. The transmittance and the reflectance of the inclined dichroic mirror 22 change according to the wavelength in the predetermined wavelength range described above.

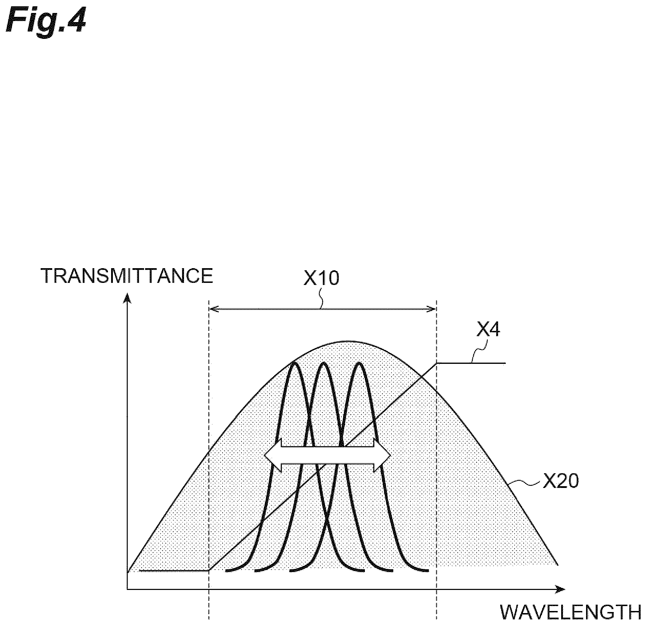

FIG. 4 is a diagram illustrating a relationship between a characteristic of the inclined dichroic mirror 22 and a wavelength of light emitted from the light irradiation unit 10. In FIG. 4, the horizontal axis represents a wavelength, and the vertical axis represents transmittance of the inclined dichroic mirror 22. As illustrated in a characteristic X4 of the inclined dichroic mirror 22 of FIG. 4, in the inclined dichroic mirror 22, the transmittance (and reflectance) of the light gently changes according to a change in wavelength in a predetermined wavelength range X10, and the transmittance (and reflectance) of the light is constant regardless of a change in wavelength in a wavelength range other than the specific wavelength range.

As illustrated in FIG. 4, light X20 output from the light irradiation unit 10 includes light of a wavelength included in the predetermined wavelength range X10 described above. That is, the light irradiation unit 10 outputs light of a broad spectrum including the predetermined wavelength range X10. Note that the wavelength range (interference peak wavelength) related to the measurement is determined based on the material of the film formed on the sample 100 and the measured film thickness range.

Returning to FIG. 1, the half mirror 11 is a mirror that reflects the light emitted from the light irradiation unit 10 in the direction of the sample 100 (specifically, the direction of the field lens 12 that guides the light to the sample 100) and transmits the light (specifically, light that has passed through the field lens 12 from the sample 100) from the sample 100 irradiated with the light. The field lens 12 is a lens that aligns the traveling direction of the light.

The camera system 20 includes a lens 21, the inclined dichroic mirror 22 (optical element), an area sensor 23 (light detection unit), and an area sensor 24 (light detection unit). Note that the camera system 20 may include a linear image sensor (detection unit) instead of the area sensor.

The lens 21 is a lens condensing the light from the sample 100 which has passed through the field lens 12 and the half mirror 11 to enter the lens 21. The lens 21 may be disposed at a preceding stage (upstream) of the inclined dichroic mirror 22, or may be disposed in a region between the inclined dichroic mirror 22 and the area sensors 23 and 24. In the present embodiment, the description will be given on the assumption that the lens 21 is disposed at the preceding stage (upstream) of the inclined dichroic mirror 22. The lens 21 may be a finite focus lens or an infinite focus lens. In a case where the lens 21 is a finite focus lens, a distance from the lens 21 to the area sensors 23 and 24 is a predetermined value. In a case where the lens 21 is an infinite focus lens, the lens 21 is a collimator lens that converts light from the sample 100 into parallel light, and aberration correction is performed so as to obtain parallel light. Light output from the lens 21 is incident on the inclined dichroic mirror 22.

The inclined dichroic mirror 22 is a mirror created using a special optical material, and is an optical element that separates light from the sample 100 by transmitting and reflecting the light according to the wavelength. That is, the inclined dichroic mirror 22 separates the first light, the second light, and the third light from the sample 100 by transmitting and reflecting the first light, the second light, and the third light. The inclined dichroic mirror 22 is configured such that transmittance and reflectance of light change according to a wavelength in a predetermined wavelength range.

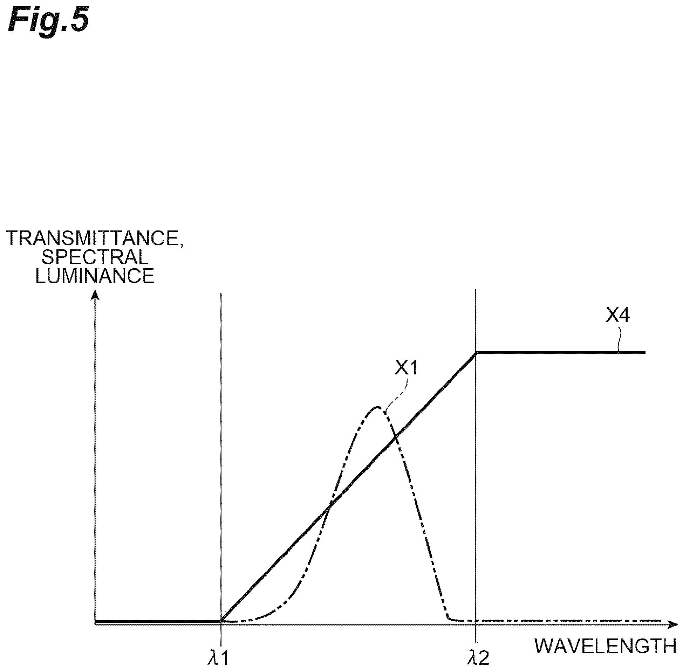

FIG. 5 is a diagram for explaining a spectrum of light and a characteristic of the inclined dichroic mirror 22. In FIG. 5, the horizontal axis represents a wavelength, and the vertical axis represents spectral intensity (in the case of the spectrum of light) and the transmittance (in the case of the inclined dichroic mirror 22). As illustrated in a characteristic X4 of the inclined dichroic mirror 22 of FIG. 5, in the inclined dichroic mirror 22, the transmittance (and reflectance) of the light gently changes according to a change in wavelength in a predetermined wavelength range (wavelength range of wavelengths $\lambda 1$ to $\lambda 2$). On the other hand, in a wavelength range other than the predetermined wavelength range (that is, the wavelength side lower than the wavelength $\lambda 1$ and the wavelength side higher than the wavelength $\lambda 2$), the transmittance (and reflectance) of light may be constant regardless of a change in wavelength. In other words, in a specific wavelength range (wavelength range of wavelengths $\lambda 1$ to $\lambda 2$), the transmittance of light monotonically increases (reflectance monotonically decreases) according to a change in wavelength. The transmittance and the reflectance have a negative correlation such that when one is changed in a direction in which the other is increased, the other is changed in a direction in which the other is decreased. Therefore, hereinafter, the transmittance and the reflectance may be simply described as "transmittance" instead of "transmittance (and reflectance)". Note that "the transmittance of light is constant regardless of a change in wavelength" includes not only a case where the transmittance is completely constant but also a case where a change in transmittance with respect to a change in wavelength of 1 nm is 0.1% or less, for example. On the wavelength side lower than the wavelength $\lambda 1$, the transmittance of light may be approximately 0% regardless of a change in wavelength, and on the wavelength side higher than the wavelength $\lambda 2$, the transmittance of light may be approximately 100% regardless of a change in wavelength. Note that "the light transmittance is approximately 0%" includes a transmittance of about 0% + 10%, and "the light transmittance is approximately 100%" includes a transmittance of about 100% - 10%. In FIG. 3, a waveform X1 indicates a waveform of light output from the light irradiation unit 10. As illustrated in the waveform X1 of FIG. 3, the light output from the light irradiation unit 10 includes light of a wavelength included in the predetermined wavelength range (wavelength range of wavelengths $\lambda 1$ to $\lambda 2$) of the inclined dichroic mirror 22.

Returning to FIG. 1, the area sensors 23 and 24 image light from the sample 100. The area sensors 23 and 24 capture (detect) light that has been separated by the inclined dichroic mirror 22. The area sensor 23 captures (detects) light that has passed through the inclined dichroic mirror 22 to output a signal according to the detection result. That is, the area sensor 23 detects the first light that has passed through the inclined dichroic mirror 22, the second light that has passed through the inclined dichroic mirror 22, and the third light that has passed through the inclined dichroic mirror 22. The area sensor 24 captures (detects) light that has been reflected by the inclined dichroic mirror 22 to output a signal according to the detection result. That is, the area sensor 24 detects the first light that has been reflected by the inclined dichroic mirror 22, the second light that has been reflected by the inclined dichroic mirror 22, and the third light that has been reflected by the inclined dichroic mirror 22. Regarding the detection of the first light, signals output from the area sensor 23 and the area sensor 24 are first signals. Regarding the detection of the second light, signals output from the area sensor 23 and the area sensor 24 are second signals. Regarding the detection of the third light, signals output from the area sensor 23 and the area sensor 24 are third signals. The range of wavelengths in which the area sensors 23 and 24 have sensitivity corresponds to a predetermined wavelength range in which transmittance (and reflectance) of light changes according to a change in wavelength in the inclined dichroic mirror 22. The area sensors 23 and 24 are, for example, monochrome sensors or color sensors. The imaging results (images) by the area sensors 23 and 24 are output to the control apparatus 30 by the first signal, the second signal, and the third signal described above.

A band pass filter (not illustrated) may be disposed at a preceding stage (upstream) of the area sensors 23 and 24. Such a band pass filter (not illustrated) may be, for example, a filter that removes light in a wavelength range other than the above-described predetermined wavelength range (in the inclined dichroic mirror 22, a wavelength range in which transmittance and reflectance of light change according to a wavelength).

The control apparatus 30 is a computer, and physically includes a memory such as a RAM and a ROM, a processor (arithmetic circuit) such as a CPU, a communication interface, and a storage unit such as a hard disk. The control apparatus 30 functions by executing a program stored in the memory by the CPU of the computer system. The control apparatus 30 may include a microcomputer or an FPGA.

The control apparatus 30 derives the film thickness of the sample 100 based on the first signal, the second signal, and the third signal which are signals from the area sensors 23 and 24 obtained by imaging the first light, the second light, and the third light. The control apparatus 30 performs, as processing related to deriving the film thickness, wavelength centroid deriving processing based on the signals from the area sensors 23 and 24 and film thickness deriving processing based on the wavelength centroid and the like. In addition, the control apparatus 30 stores relationship information between the film thickness and the wavelength centroid as the premise of performing the film thickness deriving processing. The control apparatus 30 includes the analysis unit 32 and the storage unit 33 as functional configurations that implement the processing and storage described above. The analysis unit 32 is a function of performing the wavelength centroid deriving processing and the film thickness deriving processing. The storage unit 33 stores therein the relationship information described above. Hereinafter, first, the wavelength centroid deriving processing will be described, subsequently, the relationship information between the film thickness and the wavelength centroid will be described, and then, the film thickness deriving processing will be described.

(Wavelength Centroid Deriving Processing)

The analysis unit 32 derives a wavelength centroid related to the sample 100 based on signals from the area sensors 23 and 24 that have detected light. Specifically, the analysis unit 32 derives a first wavelength centroid based on the first signal that is a signal from the area sensors 23 and 24 that have detected the first light, and derives a second wavelength centroid based on the second signal that is a signal from the area sensors 23 and 24 that have detected the second light. The analysis unit 32 further derives a third wavelength centroid based on the third signal that is a signal from the area sensors 23 and 24 that have detected the third light.

The analysis unit 32 may derive, as the wavelength centroid, the wavelength centroid of the light for each pixel based on the amount of transmitted light (the intensity of the light that has passed through the inclined dichroic mirror 22) identified based on the signal from the area sensor 23 indicating the detection result in the area sensor 23 and the amount of reflected light (the intensity of the light that has been reflected by the inclined dichroic mirror 22) identified based on the signal from the area sensor 24 indicating the detection result in the area sensor 24. Specifically, the analysis unit 32 derives the wavelength centroid of each pixel based on the following Equation (1). In the following Equation (1), x' represents the wavelength centroid, IT' represents the amount of transmitted light, and IR' represents the amount of reflected light.

$$x' = (IT' - IR')/2(IT' + IR') \qquad (1)$$

The analysis unit 32 may further derive the wavelength centroid of the light for each pixel in consideration of the central wavelength (central wavelength in a predetermined wavelength range) of the inclined dichroic mirror 22 and the width of the inclined dichroic mirror 22. The width of the inclined dichroic mirror 22 is, for example, a wavelength width from a wavelength at which transmittance becomes 0% to a wavelength at which transmittance becomes 100% in the inclined dichroic mirror 22. In this case, the analysis unit 32 may derive the wavelength centroid of each pixel based on the following Equation (2). In the following Equation (2), x' represents the wavelength centroid, IT' represents the amount of transmitted light, IR' represents the amount of reflected light, $\lambda 0$ represents the central wavelength of the inclined dichroic mirror 22, and A represents the width of the inclined dichroic mirror 22.

$$x' = \lambda 0 + A(IT' - IR')/2(IT' + IR') \qquad (2)$$

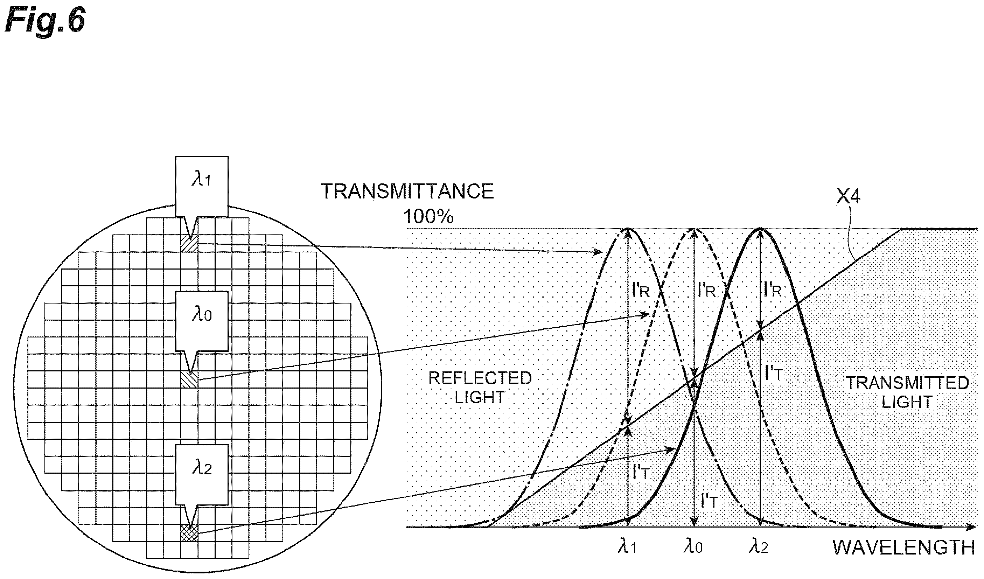

FIG. 6 is a diagram for explaining a wavelength shift according to the amount of transmitted light and the amount of reflected light. In a case where x' (the wavelength centroid) is derived by the above Equation (1) or (2), x' = λ0 (the central wavelength of the inclined dichroic mirror 22) is assumed for a pixel in which IT' (the amount of transmitted light) = IR' (the amount of reflected light), as illustrated in FIG. 6. In addition, for a pixel in which IT' < IR', that is, a pixel in which the amount of reflected light is larger than the amount of transmitted light, x' = λ1 (wavelength on a shorter wavelength side than λ0) is set. In addition, for a pixel in which IT' > IR', that is, a pixel in which the amount of transmitted light is larger than the amount of reflected light, x' = λ2 (wavelength on a longer wavelength side than λ0) is set. As described above, a value of x' (the wavelength centroid) is shifted (wavelength shift) based on the amount of transmitted light and the amount of reflected light.

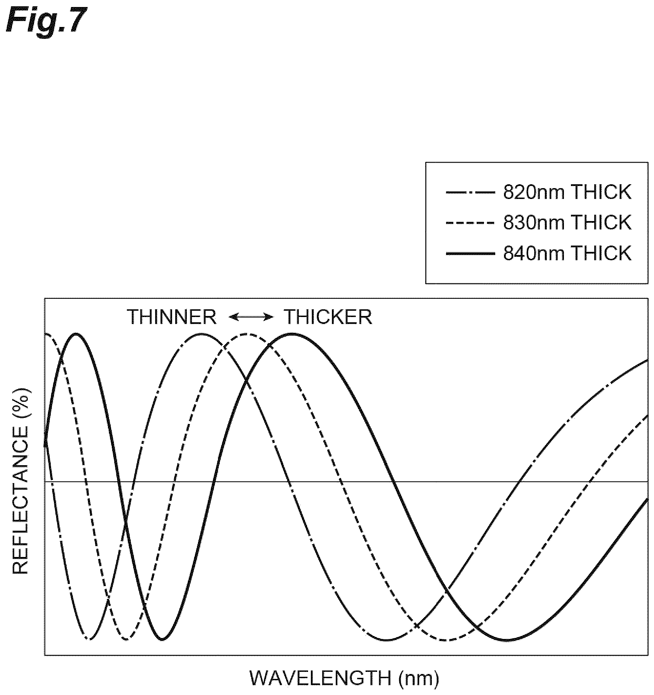

The wavelength centroid has a correlation with the film thickness and, thus, the wavelength centroid can be used to derive the film thickness. FIG. 7 is a diagram illustrating reflectance according to a wavelength for each film thickness. In FIG. 7, the horizontal axis represents a wavelength, and the vertical axis represents reflectance. In the example illustrated in FIG. 7, the relationship between the wavelength and the reflectance is illustrated for each of an example in which the film thickness is 820 nm, an example in which the film thickness is 830 nm, and an example in which the film thickness is 840 nm. As illustrated in FIG. 7, the wavelength centroid differs depending on the film thickness. As described above, since the wavelength centroid has a correlation with the film thickness, the film thickness can be estimated by identifying the wavelength centroid. The specific film thickness deriving processing will be described later.

(Relationship Information between Film Thickness and Wavelength Centroid)

Returning to FIG. 1, the storage unit 33 stores therein the relationship information between the film thickness and the wavelength centroid of the sample 100 for each wavelength of light emitted from the light irradiation unit 10. As described above, the film thickness and the wavelength centroid are correlated. Therefore, since the relationship information between the film thickness and the wavelength centroid is prepared in advance, the film thickness can be derived based on the relationship information and the wavelength centroid actually measured. The storage unit 33 stores therein the relationship information for each type of film. Specifically, the storage unit 33 stores therein the relationship information between the film thickness and the wavelength centroid of the sample 100 for each combination of the film type and the wavelength of light emitted from the light irradiation unit 10.

The relationship information may be derived based on theoretical reflectance according to the type of film and spectral characteristics (spectral sensitivity) of the entire film thickness measuring apparatus 1. When the type of film (refractive index of the film and attenuation coefficient of the film) and the film thickness are determined, the value of the theoretical reflectance for each wavelength is determined. The spectral characteristics of the entire film thickness measuring apparatus 1 are determined for each wavelength of light emitted from the light irradiation unit 10. The spectral characteristics of the entire film thickness measuring apparatus 1 may be identified (estimated) in advance by various methods. In addition, the relationship information may be derived, in advance, based on an actual measured value by making measurement related to a reference sample for perceiving the relationship between the film thickness and the wavelength centroid. In the following description, it is assumed that the relationship information is derived based on theoretical reflectance according to the type of film and the spectral characteristics (spectral sensitivity) of the entire film thickness measuring apparatus 1.

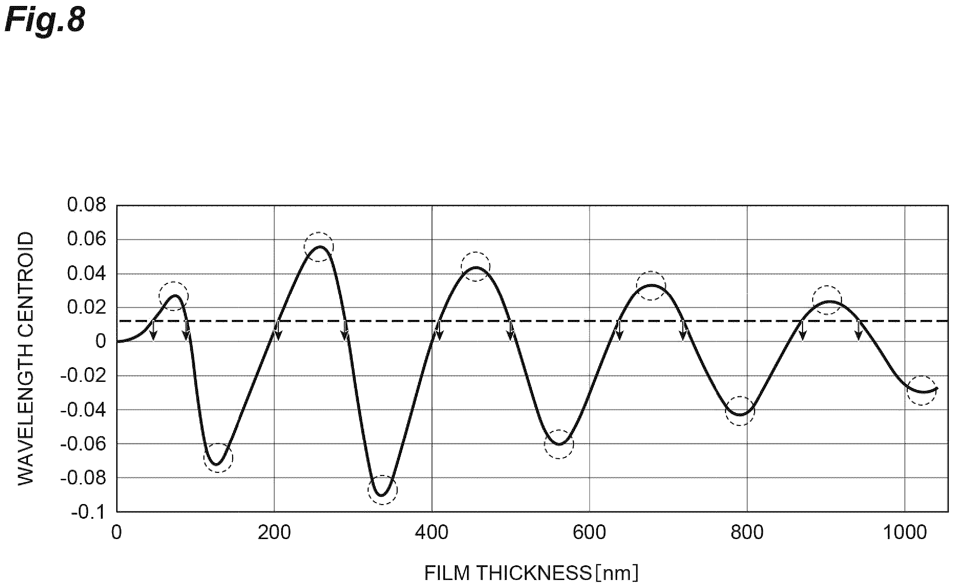

FIG. 8 illustrates a waveform indicating relationship information between a film thickness and a wavelength centroid of the sample 100. An example of estimating the film thickness based on the value of the wavelength centroid using such relationship information will be taken. In FIG. 8, the horizontal axis represents a film thickness d, and the vertical axis represents a wavelength centroid x'. Here, it is assumed that the wavelength centroid is a value indicated by a broken line extending in the lateral direction in FIG. 8. In this case, as illustrated in FIG. 8, a plurality of film thickness candidates (film thickness candidates of 10 patterns in the example illustrated in FIG. 8) is possible as the film thickness corresponding to the wavelength centroid. Therefore, the film thickness cannot be uniquely identified only from the relationship information illustrated in FIG. 8.

In addition, as illustrated in FIG. 8, the waveform indicating the relationship information has a plurality of extreme values (maximum value and minimum value) indicated by dashed circles, and the slope of the curve of the waveform is gentle (gradual) at such extreme values. At a part where the slope of the curve is gentle, the difference in film thickness due to the difference in the wavelength centroid is less noticeable, and the film thickness corresponding to the wavelength centroid cannot be accurately identified in some cases.

As described above, if an attempt is made to derive the film thickness only from the relationship information between the film thickness and the wavelength centroid of the sample 100 for the wavelength of one light emitted from the light irradiation unit 10, the film thickness cannot be accurately derived in some cases. Accordingly, the storage unit 33 stores therein the relationship information between the film thickness and the wavelength centroid of the sample 100 for a plurality of types of wavelengths (wavelengths of light emitted from the light irradiation unit 10).

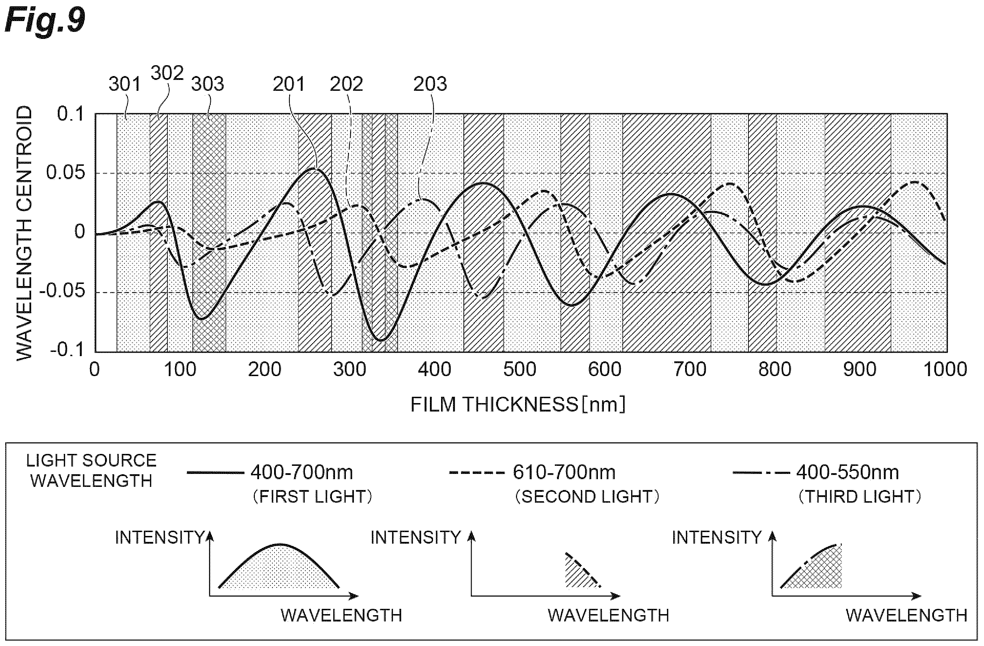

FIG. 9 illustrates a waveform indicating relationship information between a film thickness and a wavelength centroid of the sample 100 for each of a plurality of types of wavelengths (wavelengths of light emitted from the light irradiation unit 10). In the example illustrated in FIG. 9, waveforms indicating relationship information between the film thickness and the wavelength centroid of the sample 100 are illustrated for each of three types of wavelengths, that is, the first light, the second light, and the third light emitted from the light irradiation unit 10. The wavelength range of the first light is 400 to 700 nm. The wavelength range of the second light is 610 to 700 nm. The wavelength range of the third light is 400 to 550 nm.

As illustrated in FIG. 9, in the waveforms indicating the relationship information for each of the plurality of types of wavelengths, the regions of the extreme values (maximum value and minimum value) are not consistent with each other and, thus, the film thickness can be appropriately derived based on any of the waveforms. In the example illustrated in FIG. 9, as for a region 301, the film thickness can be appropriately derived based on a waveform 201 of the first light because at least the waveform 201 of the first light is far from the extreme value and the slope of the curve is relatively large, as for a region 302, the film thickness can be appropriately derived based on a waveform 202 of the second light because at least the waveform 202 of the second light is far from the extreme value and the slope of the curve is relatively large, and as for a region 303, the film thickness can be appropriately derived based on a waveform 203 of the third light because at least the waveform 203 of the third light is far from the extreme value and the slope of the curve is relatively large. In a case where a film thickness candidate is derived from a waveform indicating relationship information for each of a plurality of types of wavelengths, the film thickness can be uniquely derived by taking into account the consistency or the like of the film thickness candidates for each of the plurality of wavelengths (details will be described later).

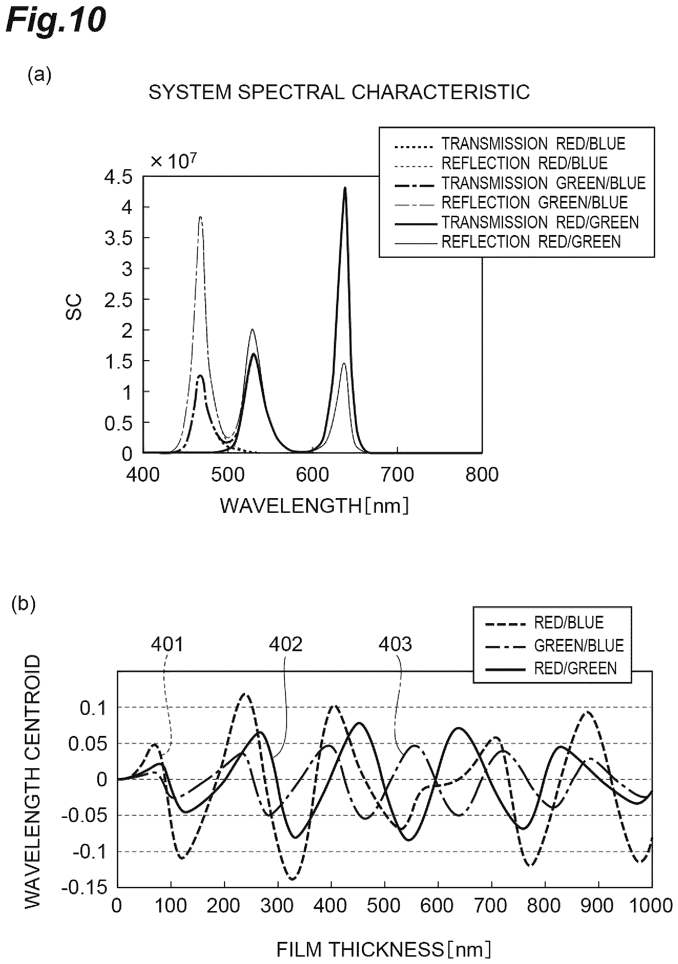

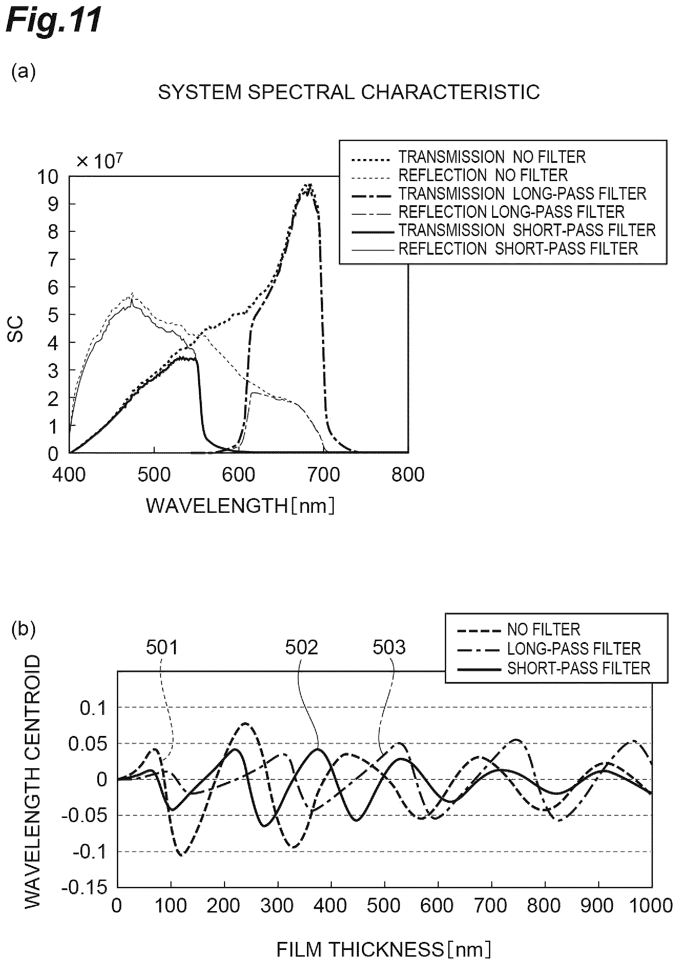

An example of the waveform indicating the relationship information stored in the storage unit 33 will be described with reference to FIGS. 10 and 11. As described above, the relationship information between the film thickness and the wavelength centroid is derived based on the theoretical reflectance according to the type of film and the spectral characteristics (spectral sensitivity) of the entire film thickness measuring apparatus 1. FIG. 10(a) is a diagram illustrating a system spectral characteristic according to a wavelength for each combination of monochromatic light in the configuration illustrated in FIG. 2 (configuration using the multicolor LED array light source 10a). In FIG. 10(a), the horizontal axis represents a wavelength, and the vertical axis represents spectral characteristics. As illustrated in FIG. 10(a), the spectral characteristics on the transmission side and the reflection side are derived for each combination of monochromatic light. Specifically, the relationship information is derived by deriving an expected value of the wavelength centroid based on the theoretical reflectance and the spectral characteristics of the film thickness measuring apparatus 1 and deriving a relationship equation by curve fitting after plotting the expected value of the wavelength centroid. Examples of the curve fitting method include a polynomial approximation method and other curve fitting methods. A curve indicating the relationship between the wavelength and the spectral intensity may be derived using a method other than the curve fitting, an interpolation method for example.

In a case where the type of film is fixed, the value of the theoretical reflectance for each wavelength is determined according to the film thickness. It is assumed that a certain film thickness is designated and the value of the theoretical reflectance for each wavelength is determined. In this case, the expected value of the amount of transmitted light measured by the area sensor 23 can be estimated based on the theoretical reflectance for each wavelength and the spectral characteristics on the transmission side of the film thickness measuring apparatus 1 for each wavelength. Since the area sensor 23 does not have a spectral function, the expected value of the amount of transmitted light measured by the area sensor 23 is a value obtained by integrating the intensity of light for each wavelength. Similarly, the expected value of the amount of reflected light measured by the area sensor 24 can be estimated based on the theoretical reflectance for each wavelength and the spectral characteristics on the reflection side of the film thickness measuring apparatus 1 for each wavelength. Then, the expected value of the wavelength centroid can be derived from the expected value of the amount of transmitted light and the expected value of the amount of reflected light using Equation (1) or (2) mentioned above. As described above, in a state where the type of film is fixed, an expected value of the wavelength centroid at a certain film thickness can be derived. Then, the expected value of the wavelength centroid at each film thickness is derived while changing the film thickness condition with the same film type. As a result, for a certain film type, an expected value of the wavelength centroid for each of a plurality of film thickness conditions is derived. Here, it is assumed that an expected value of the wavelength centroid for each of a plurality of film thickness conditions is derived for a certain film type. Then, curve fitting is performed on data in which a plurality of film thicknesses and expected values of the wavelength centroid are plotted, thereby deriving a waveform (curve) indicating a relationship between the film thickness $d$ and the wavelength centroid $x'$. Examples of the curve fitting method include a polynomial approximation method and other curve fitting methods. A curve indicating the relationship between the wavelength and the spectral intensity may be derived using a method other than the curve fitting, an interpolation method for example.

Such a curve is derived for each combination of monochromatic light illustrated in FIG. 10(a) (that is, for the first light to the third light) and, thereby, as illustrated in FIG. 10(b), a waveform 401 indicating the relationship information regarding the first light, a waveform 402 indicating the relationship information regarding the second light, and a waveform 403 indicating the relationship information regarding the third light are derived. The storage unit 33 stores therein such waveforms 401 to 403 as waveforms indicating relationship information between the film thickness and the wavelength centroid of the sample 100 for the first light to the third light.

FIG. 11(a) is a diagram illustrating a system spectral characteristic according to a wavelength for each setting filter in the configuration illustrated in FIG. 3 (configuration using the white light source 10b and the filter switching mechanism 10c). In FIG. 11(a), the horizontal axis represents a wavelength, and the vertical axis represents spectral characteristics. As illustrated in FIG. 11(a), the spectral characteristics on the transmission side and the reflection side are derived for each of the following situations: no filter, a long-pass filter set, and a short-pass filter set. Here, it is assumed that the light from the white light source 10b in the case of no filter is the first light having the first wavelength. It is also assumed that the light from the white light source 10b passing through the short-pass filter is the second light having the second wavelength. It is also assumed that the light from the white light source 10b passing through the long-pass filter is the third light having the third wavelength. Then, in a similar method to the above method, an expected value of the wavelength centroid is derived based on the theoretical reflectance and the spectral characteristics of the film thickness measuring apparatus 1 and a relationship equation is derived by curve fitting after plotting the expected value of the wavelength centroid, so that waveforms indicating the relationship information between the film thickness and the wavelength centroid are derived for the first light to the third light. That is, as illustrated in FIG. 11(b), a waveform 501 indicating the relationship information regarding the first light, a waveform 502 indicating the relationship information regarding the second light, and a waveform 503 indicating the relationship information regarding the third light are derived. The storage unit 33 stores therein such waveforms 501 to 503 as waveforms indicating relationship information between the film thickness and the wavelength centroid of the sample 100 for the first light to the third light.

(Film Thickness Deriving Processing)

The analysis unit 32 derives at least one first film thickness candidate based on the relationship information between the film thickness and the wavelength centroid of the sample 100 at the first wavelength (wavelength of the first light) and the first wavelength centroid derived based on the first signal. Similarly, the analysis unit 32 derives at least one second film thickness candidate based on the relationship information between the film thickness and the wavelength centroid of the sample 100 at the second wavelength (wavelength of the second light) and the second wavelength centroid derived based on the second signal. Similarly, the analysis unit 32 derives at least one third film thickness candidate based on the relationship information between the film thickness and the wavelength centroid of the sample 100 at the third wavelength (wavelength of the third light) and the third wavelength centroid derived based on the third signal. Then, the analysis unit 32 derives the film thickness of the sample 100 based on the first film thickness candidate, the second film thickness candidate, and the third film thickness candidate.

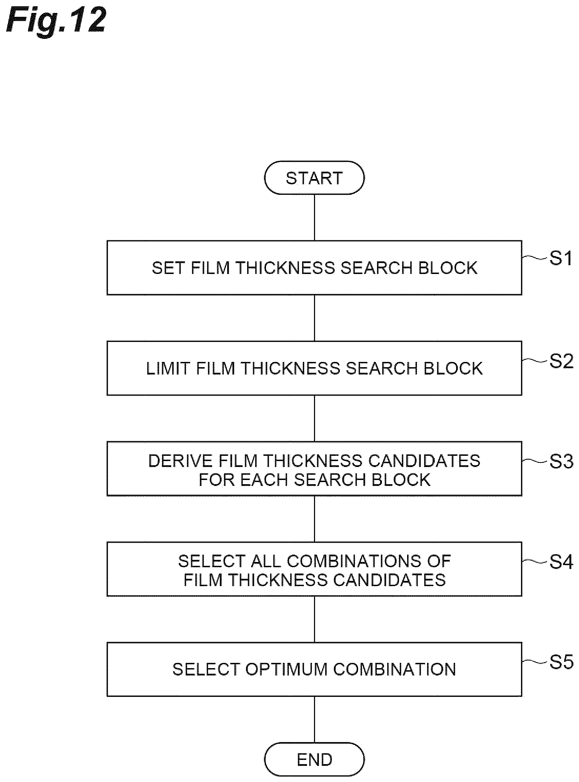

A specific process of deriving the film thickness will be described with reference to FIGS. 12 to 18. FIG. 12 is a flowchart illustrating a specific process of film thickness measurement (film thickness deriving). As illustrated in FIG. 12, in the film thickness deriving processing, first, a film thickness search block is set (step S1).

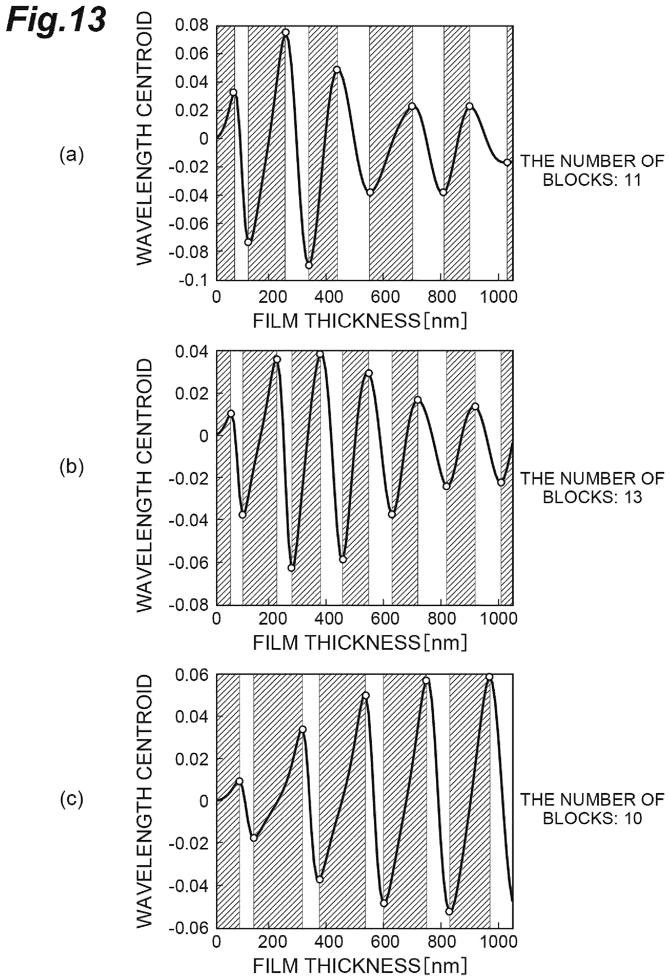

FIGS. 13(a) to 13(c) are diagrams for explaining film thickness search block settings for each of three wavelength patterns different from each other. Here, the three wavelength patterns mean a wavelength pattern 1 of the first wavelength (wavelength of the first light), a wavelength pattern 2 of the second wavelength (wavelength of the second light), and a wavelength pattern 3 of the third wavelength (wavelength of the third light). FIG. 13(a) is a diagram for explaining the setting of the film thickness search block in the relationship information for the wavelength pattern 1. FIG. 13(b) is a diagram for explaining the setting of the film thickness search block in the relationship information for the wavelength pattern 2. FIG. 13(c) is a diagram for explaining the setting of the film thickness search block in the relationship information for the wavelength pattern 3. As illustrated in FIGS. 13(a) to 13(c), in the setting of the film thickness search block, an extreme value is determined for each piece of relationship information of each wavelength pattern, and a part between the extreme values is set as one film thickness search block. In this case, 11 film thickness search blocks are set in the relationship information for the wavelength pattern 1 illustrated in FIG. 13(a). In the relationship information for the wavelength pattern 2 illustrated in FIG. 13(b), 13 film thickness search blocks are set. In the relationship information for the wavelength pattern 3 illustrated in FIG. 13(c), 10 film thickness search blocks are set.

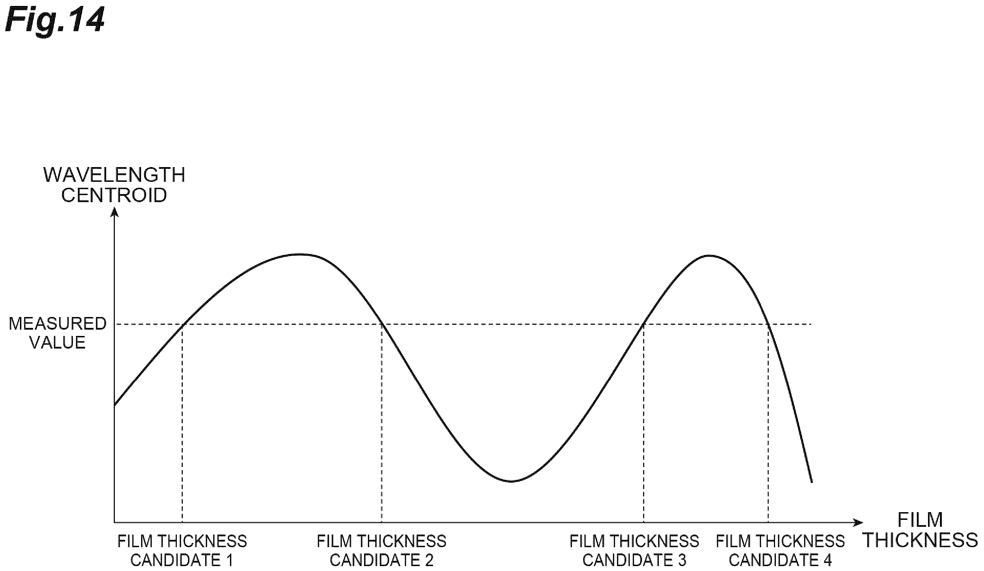

As illustrated in FIG. 12, subsequently, a film thickness search block from which a film thickness candidate is to be derived is limited (step S2). FIG. 14 is a diagram for explaining derivation of film thickness candidates for a case where the film thickness search block is not limited. As illustrated in FIG. 14, in a case where a film thickness candidate is derived based on the measured value of the wavelength centroid, since there is a plurality of film thickness candidates, deriving the film thickness candidates for all the film thickness search blocks needs time to derive the film thickness candidates.

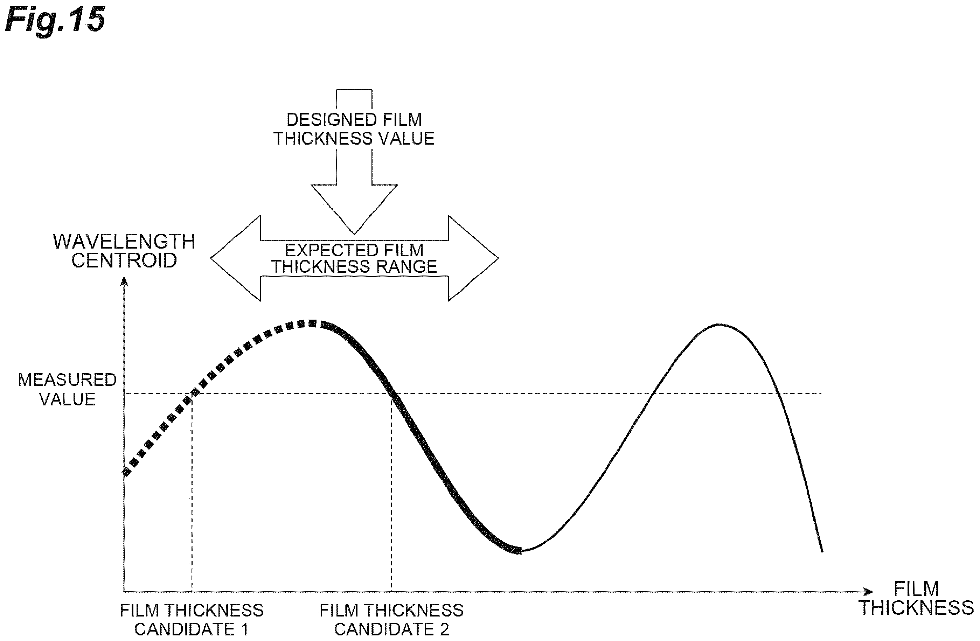

In view of this, in the film thickness deriving processing according to the present embodiment, a film thickness search block from which a film thickness candidate is to be derived is limited. FIG. 15 is a diagram for explaining derivation of film thickness candidates according to an expected film thickness range. As illustrated in FIG. 15, the analysis unit 32 sets an expected film thickness range from a designed film thickness value in advance, and derives film thickness candidates (first to third film thickness candidates) only from within the expected film thickness range. More specifically, the analysis unit 32 sets only film thickness search blocks within the expected film thickness range as film thickness search blocks from which a film thickness candidate is to be derived, and derives film thickness candidates only from the film thickness search block from which a film thickness candidate is to be derived.

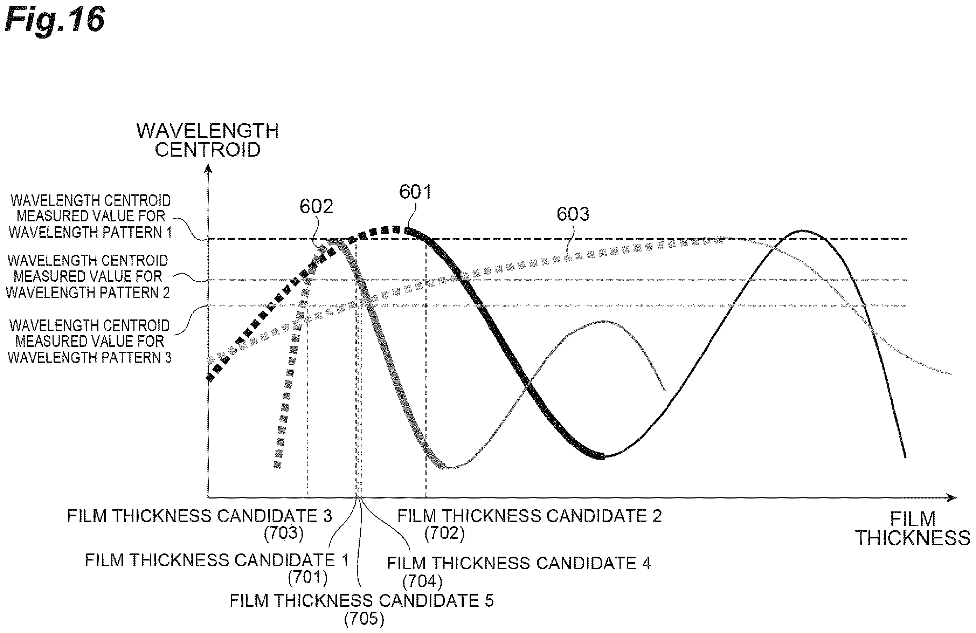

As illustrated in FIG. 12, subsequently, a film thickness candidate is derived for each film thickness search block from which a film thickness candidate is to be derived (step S3). FIG. 16 is a diagram for explaining derivation of film thickness candidates for each wavelength pattern. FIG. 16 illustrates a waveform 601 for the relationship information regarding the wavelength pattern 1, a waveform 602 for the relationship information regarding the wavelength pattern 2, and a waveform 603 for the relationship information regarding the wavelength pattern 3. Here, the film thickness search block is limited according to the expected film thickness range, and a thin line portion of each of the waveforms 601, 602, and 603 is excluded from the target from which a film thickness candidate is to be derived. As for the waveform 601 for the wavelength pattern 1, two film thickness candidates, namely, a film thickness candidate 1 and a film thickness candidate 2, are derived based on the measured value of the wavelength centroid. As for the waveform 602 for the wavelength pattern 2, two film thickness candidates, namely, a film thickness candidate 3 and a film thickness candidate 4, are derived based on the measured value of the wavelength centroid. As for the waveform 603 for the wavelength pattern 3, one film thickness candidate 5 is derived based on the measured value of the wavelength centroid.

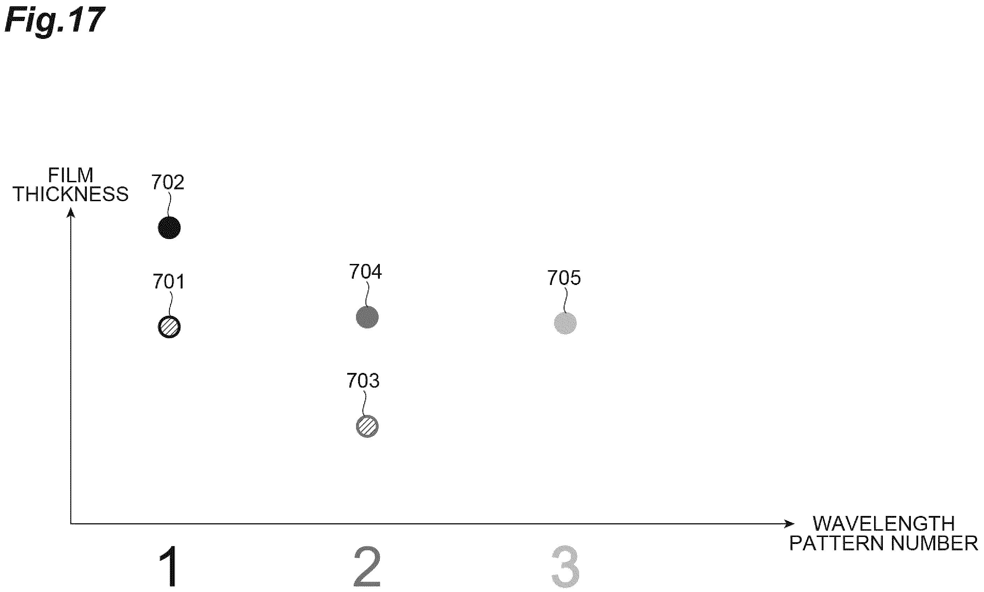

FIG. 17 is a diagram illustrating derived film thickness candidates. In FIG. 17, the horizontal axis represents wavelength pattern No, and the vertical axis represents a film thickness. As illustrated in FIG. 17, the film thickness candidates 1 to 5 described above are indicated by a film thickness 701, a film thickness 702, a film thickness 703, a film thickness 704, and a film thickness 705, respectively. That is, the film thickness 701 and the film thickness 702 larger than the film thickness 701 are illustrated as the film thickness candidates for the wavelength pattern 1. As the film thickness candidates for the wavelength pattern 2, the film thickness 704 and the film thickness 703 smaller than the film thickness 704 are illustrated. The film thickness 705 is illustrated as the film thickness candidate for the wavelength pattern 3. As illustrated in FIG. 17, the film thicknesses 701, 704, and 705 are similar in size (thickness) to each other.

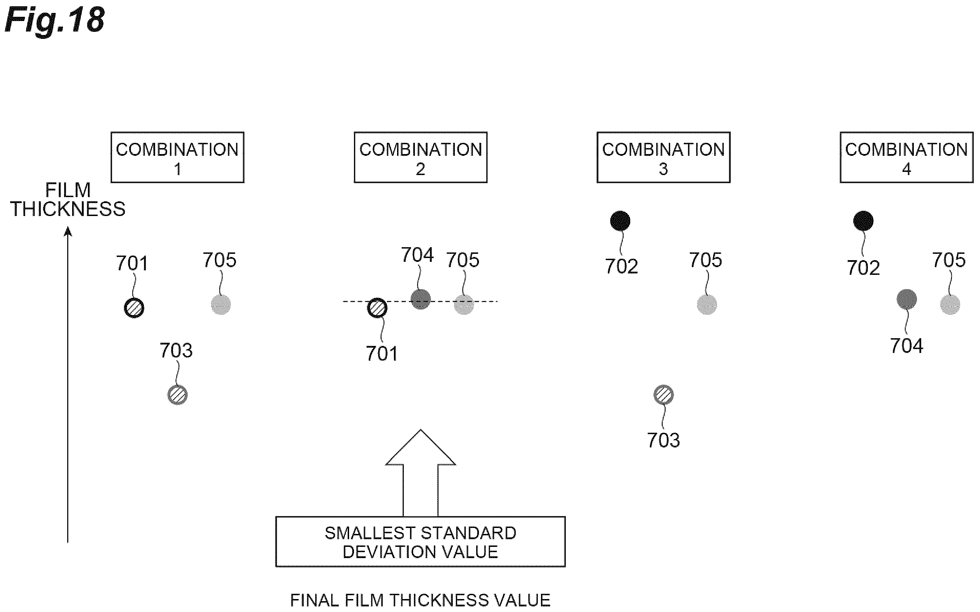

As illustrated in FIG. 12, subsequently, all combinations of the film thickness candidates are selected so that one film thickness candidate for each wavelength pattern is included (step S4). FIG. 18 is a diagram for explaining derivation of film thickness based on selection of an optimum combination of film thickness candidates. In FIG. 18, the vertical axis represents a film thickness. As illustrated in FIG. 18, as combinations that include one film thickness candidate for each wavelength pattern, a combination 1 including the film thicknesses 701, 703, and 705, a combination 2 including the film thicknesses 701, 704, and 705, a combination 3 including the film thicknesses 702, 703, and 705, and a combination 4 including the film thicknesses 702, 704, and 705 are selected.

As illustrated in FIG. 12, finally, an optimum combination is selected from among the combinations of film thicknesses (step S5) described above. The optimum combination herein refers to a combination in which the standard deviation value of each film thickness included in the combination is the smallest. As illustrated in FIG. 18, the combination 2 including the film thicknesses 701, 704, and 705 has the smallest standard deviation value of the film thickness and, thus, the combination 2 is selected as the optimum combination. Then, the values of the film thicknesses 701, 704, and 705 included in the combination 2 (for example, an average value thereof) is derived as a final film thickness value.

Next, functional effects of the film thickness measuring apparatus 1 according to the present embodiment will be described.

The film thickness measuring apparatus 1 measures the film thickness of the sample 100 in which the film 100b is formed on the substrate 100a. The film thickness measuring apparatus 1 includes: the light irradiation unit 10 configured to irradiate the sample 100 with each of the first light having the first wavelength and the second light having the second wavelength different from the first wavelength; the inclined dichroic mirror 22 that have transmittance and reflectance changing according to the wavelength in a predetermined wavelength range, and transmits and reflects the first light and the second light from the sample 100 to separate the first light and the second light; the area sensors 23 and 24 configured to detect the first light that has been reflected by the inclined dichroic mirror 22 and the first light that has passed through the inclined dichroic mirror 22 to output the first signal, and configured to detect the second light that has been reflected by the inclined dichroic mirror 22 and the second light that has passed through the inclined dichroic mirror 22 to output the second signal; and the analysis unit 32 configured to derive the first wavelength centroid based on the first signal and derive the second wavelength centroid based on the second signal. The analysis unit 32 derives at least one first film thickness candidate based on the relationship information between the film thickness and the wavelength centroid of the sample 100 at the first wavelength, and the first wavelength centroid, derives at least one second film thickness candidate based on the relationship information between the film thickness and the wavelength centroid of the sample 100 at the second wavelength, and the second wavelength centroid, and derives the film thickness of the sample 100 based on the first film thickness candidate and the second film thickness candidate.

In the film thickness measuring apparatus 1 according to the present embodiment, the sample 100 is irradiated with the first light having the first wavelength, the first light from the sample 100 which has been reflected by the inclined dichroic mirror 22 and the first light that has passed through the sample 100 are detected and the first signal is output, and the first wavelength centroid is derived based on the first signal. Then, at least one first film thickness candidate is derived based on the relationship information between the film thickness and the wavelength centroid of the sample 100 at the predetermined first wavelength, and the derived first wavelength centroid. Further, in the film thickness measuring apparatus 1 according to the present embodiment, the sample 100 is irradiated with the second light having the second wavelength, the second light from the sample 100 which has been reflected by the inclined dichroic mirror 22 and the second light that has passed through the inclined dichroic mirror 22 are detected and the second signal is output, and the second wavelength centroid is derived based on the second signal. Then, at least one second film thickness candidate is derived based on the relationship information between the film thickness and the wavelength centroid of the sample 100 at the predetermined second wavelength, and the derived second wavelength centroid. Further, in the film thickness measuring apparatus 1 according to the present embodiment, the film thickness of the sample 100 is derived based on the first film thickness candidate and the second film thickness candidate described above.

As described above, in the film thickness measuring apparatus 1 according to the present embodiment, one or a plurality of film thickness candidates is derived based on light of a plurality of wavelengths different from each other. For example, in a case where the film thickness is to be derived based on the relationship information between the film thickness and the wavelength centroid of the sample 100 at a certain type of wavelength and on the derived wavelength centroid, there is a plurality of candidates for the film thickness corresponding to the derived wavelength centroid, which makes it impossible to uniquely identify the film thickness in some cases. In addition, depending on the shape of the waveform indicating the relationship information between the film thickness and the wavelength centroid, the extreme values of the waveform are smoothed, the difference in film thickness due to the difference in the wavelength centroid is less noticeable, and the film thickness corresponding to the wavelength centroid cannot be accurately derived in some cases. In this regard, as described above, one or a plurality of film thickness candidates is derived based on light of a plurality of wavelengths different from each other and, thus, even in a case where the film thickness cannot be uniquely determined with light of one wavelength, the film thickness of the sample 100 can be appropriately derived based on the film thickness candidates by taking into account of consistency or the like of the film thickness candidates for **each of** the light of a plurality of wavelengths. In addition, as for the light of a plurality of wavelengths different from each other, extreme values (range in which the film thickness cannot be accurately derived) of the waveform indicating the relationship information between the film thickness and the wavelength centroid are not consistent with each other, and thus the film thickness of the sample 100 can be appropriately derived based on each of the film thickness candidates. As described above, according to the film thickness measuring apparatus 1 of the present embodiment, the film thickness of the sample 100 can be measured with high accuracy.

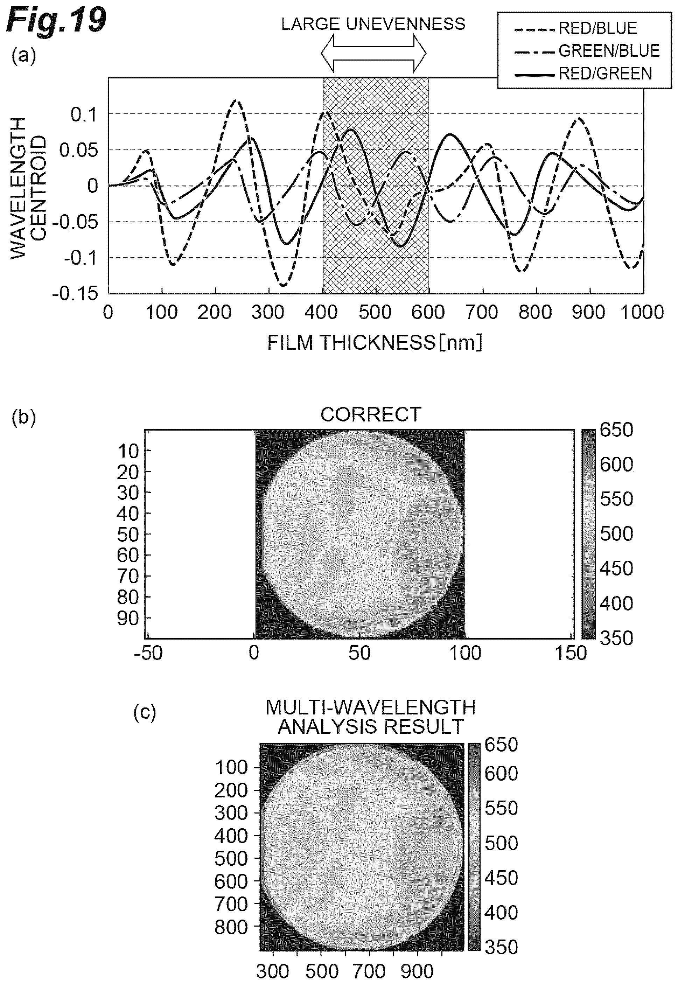

FIG. 19(a) is a diagram for explaining derivation of film thickness in the sample 100 having large film thickness unevenness. For example, as illustrated in FIG. 19(a), even in the sample 100 (sample 100 such as an oxide film) having film thickness unevenness of about 500 nm $\pm$ 100 nm, according to the method using the film thickness measuring apparatus 1 of the present embodiment, the film thickness can be measured in a high range, so that the film thickness can be measured with high accuracy.

FIG. 19(b) is an example of correct data of film thickness. FIG. 19(c) is a diagram illustrating a multi-wavelength analysis result corresponding to the correct data illustrated in FIG. 19(b). In FIGS. 19(b) and 19(c), the horizontal axis and the vertical axis indicate positions on the sample 100. In FIGS. 19(b) and 19(c), the color shading indicates the film thickness. As illustrated in FIGS. 19(b) and 19(c), according to the method (that is, film thickness deriving based on multi-wavelength analysis) of the film thickness measuring apparatus 1 of the present embodiment described above, it is possible to perform highly accurate film thickness measurement having a high degree of agreement with correct data of the film thickness.

The light irradiation unit 10 further irradiates the sample 100 with the third light having the third wavelength different from the first wavelength and the second wavelength, the inclined dichroic mirror 22 transmits and reflects the third light from the sample 100 to further separate the third light, the area sensors 23 and 24 further detect the third light that has been reflected by the inclined dichroic mirror 22 and the third light that has passed through the inclined dichroic mirror 22 to output the third signal, the analysis unit 32 further derives the third wavelength centroid based on the third signal, and further derives at least one third film thickness candidate based on the relationship information between the film thickness and the wavelength centroid of the sample 100 at the third wavelength, and the third wavelength centroid, and the film thickness of the sample 100 may be derived based on the first film thickness candidate, the second film thickness candidate, and the third film thickness candidate. In this way, one or a plurality of film thickness candidates is derived based on light of three types of wavelengths different from each other, which makes it easier to identify the film thickness uniquely as compared with the case of using light of two types of wavelengths. As a result, the film thickness of the sample 100 can be measured with higher accuracy.

The analysis unit 32 may set, in advance, an expected film thickness range from a designed film thickness value, and derive the first film thickness candidate and the second film thickness candidate only from within the expected film thickness range. In a case where the expected film thickness range is assumed in advance, the processing time related to the film thickness derivation can be shortened by deriving the film thickness candidate only from within the expected film thickness range.

The light irradiation unit 10 includes the multicolor LED array light source 10a configured to emit monochromatic light of three or more wavelengths and may irradiate the sample 100 with the first light configured by simultaneously emitting monochromatic light of two wavelengths among the monochromatic light of three or more wavelengths. In the waveform indicating the relationship information between the film thickness and the wavelength centroid, the wider the wavelength width of light, the steeper the slope of the curve, and the narrower the wavelength width of light, the gentler the slope of the curve. The steeper the slope of the waveform curve, the greater the change in film thickness with respect to the change in wavelength centroid and, thus, the film thickness can be accurately derived. Therefore, by simultaneously emitting the monochromatic light of two wavelengths and widening the wavelength width of the first light, the curve in the waveform indicating the relationship information between the film thickness and the wavelength centroid can be made steeper, and the film thickness of the sample 100 can be measured with higher accuracy.

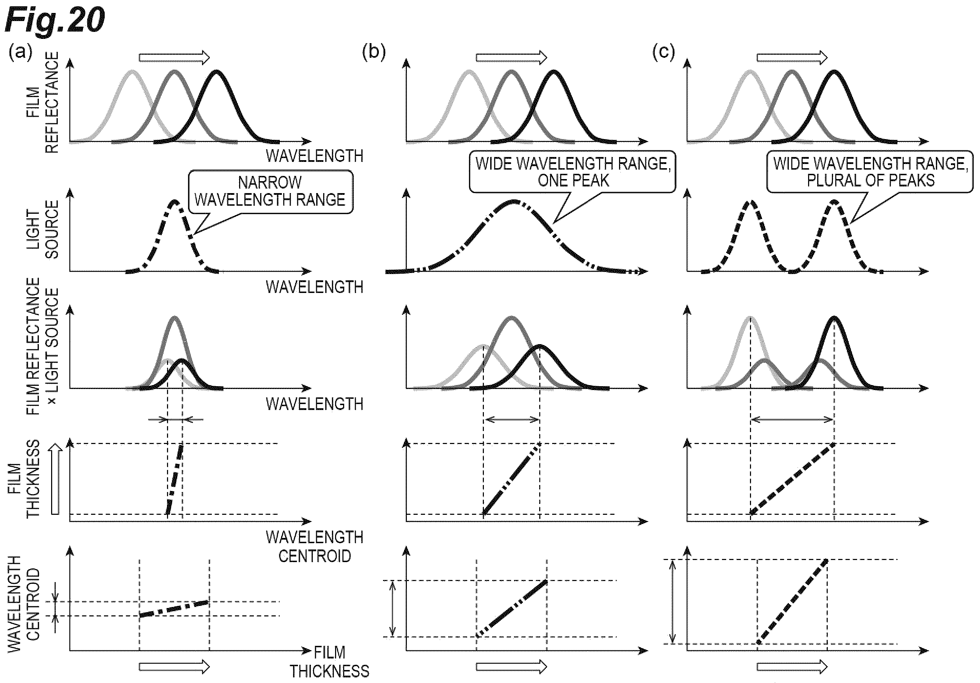

FIG. 20(a) is a diagram illustrating a relationship between a wavelength centroid and a film thickness for a case where light having a relatively narrow wavelength range (wavelength width) is used. FIG. 20(b) is a diagram illustrating a relationship between a wavelength centroid and a film thickness for a case where light having a relatively wide wavelength range (wavelength width) is used. FIG. 20(c) is a diagram illustrating a relationship between a wavelength centroid and a film thickness for a case where light having a relatively wide wavelength range (wavelength width) and a plurality of peaks (two maximum values) is used. In FIGS. 20(a) to 20(c), the conditions of film reflectance are the same, and the film reflectance changes according to a change in the film thickness. Here, as illustrated in FIGS. 20(a) and 20(b), in a case where the wavelength range of the light emitted from the light source is relatively narrow, the slope of the curve in the waveform indicating the relationship information between the film thickness and the wavelength centroid is smaller than that in a case where the wavelength range of the light is relatively wide. In this case, the change in the film thickness becomes small with respect to the change in the wavelength centroid, which makes it difficult to accurately derive the film thickness. On the other hand, by widening the wavelength range (wavelength width) of the light emitted from the light source, accuracy of deriving the film thickness can be increased. In addition, as illustrated in FIGS. 20(b) and 20(c), light having a relatively wide wavelength range (wavelength width) and a plurality of peaks (two maximum values) is used, which further increases the slope of the curve in the waveform indicating the relationship information between the film thickness and the wavelength centroid as compared with the case of using light having one peak (one maximum value), resulting in the increase in accuracy of deriving the film thickness.

Monochromatic light of two wavelengths emitted from the multicolor LED array light source 10a may be light of a red wavelength and light of a blue wavelength. As described above, the monochromatic light of two wavelengths is the light of the red wavelength and the light of the blue wavelength having a large difference in wavelength, so that the wavelength width of the first light is increased, and the film thickness of the sample 100 can be measured with higher accuracy. The light of a red wavelength is light with a wavelength of a part of the wavelength range of 610 nm or more and 780 nm or less, the light of a green wavelength is light with a wavelength of a part of the wavelength range of 500 nm or more and 570 nm or less, and the monochromatic light of a blue wavelength is light with a wavelength of a part of the wavelength range of 430 nm or more and 490 nm or less.

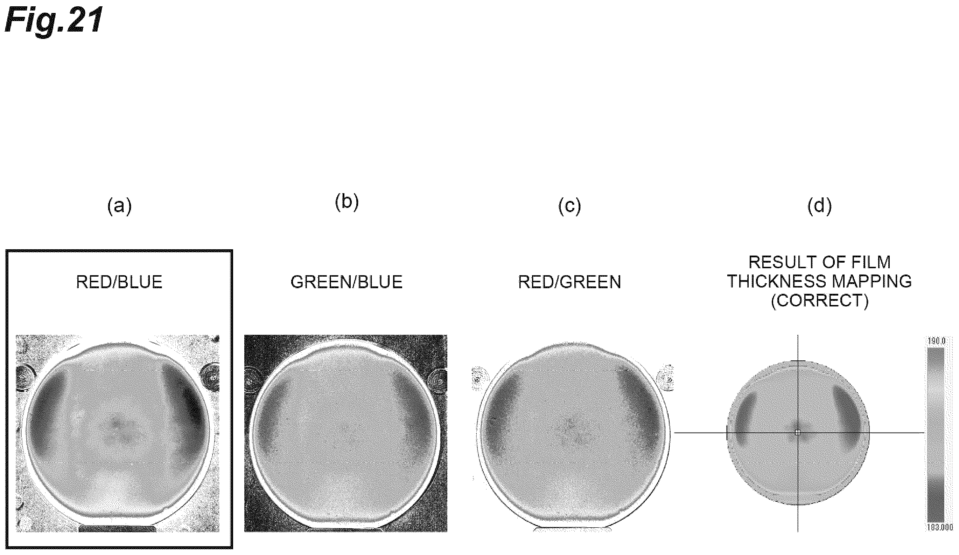

FIG. 21(a) is a diagram illustrating a result of film thickness mapping for a case where light of a red wavelength and light of a blue wavelength are used. FIG. 21(b) is a diagram illustrating a result of film thickness mapping for a case where light of a green wavelength and light of a blue wavelength are used. FIG. 21(c) is a diagram illustrating a result of film thickness mapping for a case where light of a red wavelength and light of a green wavelength are used. FIG. 21(d) is a diagram illustrating correct data of a result of film thickness mapping. Here, an example of a case will be described in which film thickness mapping (mapping the film thickness of each region of the sample 100) is performed while changing the combination of the monochromatic light of two wavelengths emitted from the multicolor LED array light source 10a and keeping the other conditions the same. FIG. 21(d) illustrates correct data of the film thickness mapping. As illustrated in FIGS. 21(a) to 21(d), in a case where the combination of the monochromatic light of two wavelengths is the red wavelength and the blue wavelength (see FIG. 21(a)), the degree of agreement with the correct data for the film thickness is the highest. That is, the monochromatic light of two wavelengths is the light of the red wavelength and the light of the blue wavelength having a large difference in wavelength, so that the film thickness of the sample 100 can be measured with high accuracy.

Finally, various exemplary embodiments included in the present disclosure are described in the following [E1] to [E6].

[E1]

A film thickness measuring apparatus for measuring a film thickness of an object having a film formed on a substrate, the film thickness measuring apparatus including:

a light irradiation unit configured to irradiate the object with each of first light having a first wavelength and second light having a second wavelength different from the first wavelength;
an optical element having transmittance and reflectance changing according to a wavelength in a predetermined wavelength range, the optical element configured to transmit and reflect the first light and the second light from the object to separate the first light and the second light;

a light detection unit configured to detect the first light that has been reflected by the optical element and the first light that has passed through the optical element to output a first signal, and configured to detect the second light that has been reflected by the optical element and the second light that has passed through the optical element to output a second signal; and

an analysis unit configured to derive a first wavelength centroid based on the first signal and derive a second wavelength centroid based on the second signal, in which

the analysis unit includes

deriving at least one first film thickness candidate based on relationship information between the film thickness and a wavelength centroid of the object at the first wavelength, and the first wavelength centroid,

deriving at least one second film thickness candidate based on relationship information between the film thickness and a wavelength centroid of the object at the second wavelength, and the second wavelength centroid, and

deriving the film thickness of the object based on the first film thickness candidate and the second film thickness candidate.

[E2]

The film thickness measuring apparatus according to [E1], in which the light irradiation unit further irradiates the object with third light having a third wavelength different from the first wavelength and the second wavelength,

the optical element transmits and reflects the third light from the object to further separate the third light,
the light detection unit further detects the third light that has been reflected by the optical element and the third light that has passed through the optical element to output a third signal,
the analysis unit
further derives a third wavelength centroid based on the third signal, and further derives at least one third film thickness candidate based on relationship information between the film thickness and a wavelength centroid of the object at the third wavelength, and the third wavelength centroid, and
derives the film thickness of the object based on the first film thickness candidate, the second film thickness candidate, and the third film thickness candidate.

[E3]

The film thickness measuring apparatus according to [E1] or [E2], in which the analysis unit sets, in advance, an expected film thickness range from a designed film thickness value, and derives the first film thickness candidate and the second film thickness candidate only from within the expected film thickness range.

[E4]

The film thickness measuring apparatus according to any one of [E1] to [E3], in which the light irradiation unit

includes a light source configured to emit monochromatic light of three or more wavelengths, and
irradiates the object with the first light configured by simultaneously emitting monochromatic light of two wavelengths among the monochromatic light of three or more wavelengths.

[E5]

The film thickness measuring apparatus according to [E4], in which the monochromatic light of two wavelengths is light of a red wavelength and light of a blue wavelength.

[E6]

A film thickness measuring method executed by a film thickness measuring apparatus for measuring a film thickness of an object having a film formed on a substrate, the film thickness measuring method including:

a first irradiation step of irradiating the object with first light having a first wavelength;
a first separation step of using an optical element having transmittance and reflectance changing according to a wavelength in a predetermined wavelength range to transmit and reflect the first light from the object;

a first light detection step of detecting the first light that has been reflected by the optical element and the first light that has passed through the optical element to output a first signal;

a first calculation step of deriving a first wavelength centroid based on the first signal and deriving at least one first film thickness candidate based on relationship information between the film thickness and a wavelength centroid of the object at the first wavelength, and the first wavelength centroid;

a second irradiation step of irradiating the object with second light having a second wavelength different from the first wavelength;

a second separation step of using the optical element to transmit and reflect the second light from the object;

a second light detection step of detecting the second light that has been reflected by the optical element and the second light that has passed through the optical element to output a second signal;

a second calculation step of deriving a second wavelength centroid based on the second signal and deriving at least one second film thickness candidate based on relationship information between the film thickness and a wavelength centroid of the object at the second wavelength, and the second wavelength centroid; and

an analysis step of deriving the film thickness of the object based on said at least one first film thickness candidate determined in the first calculation step and said at least one second film thickness candidate determined in the second calculation step.

[E7]

The film thickness measuring method according to [E6], further including a third irradiation step of further irradiating the object with third light having a third wavelength different from the first wavelength and the second wavelength,

a third separation step of transmitting and reflecting the third light from the object to further separate the third light,

a third light detection step of further detecting the third light that has been reflected by the optical element and the third light that has passed through the optical element to output a third signal, and

a third calculation step of further deriving a third wavelength centroid based on the third signal, and further deriving at least one third film thickness candidate based on relationship information between the film thickness and a wavelength centroid of the object at the third wavelength, and the third wavelength centroid, in which

in the analysis step, the film thickness of the object is derived based on the first film thickness candidate, the second film thickness candidate, and the third film thickness candidate.

[E8]

The film thickness measuring method according to [E6] or [E7], in which, in the analysis step, an expected film thickness range is set from a designed film thickness value in advance, and the first film thickness candidate and the second film thickness candidate are derived only from within the expected film thickness range.

[E9]

The film thickness measuring apparatus according to any one of [E6] to [E8], in which, in the first irradiation step, the object is irradiated with the first light configured by simultaneously emitting monochromatic light of two wavelengths among monochromatic light of three or more wavelengths emitted from a light source configured to emit the monochromatic light of three or more wavelengths.

[E10]

The film thickness measuring method according to [E9], in which the monochromatic light of two wavelengths is light of a red wavelength and light of a blue wavelength.

**Reference Signs List**

1 Film thickness measuring apparatus
10 Light irradiation unit
10a Multicolor LED array light source (light source)
22 Inclined dichroic mirror (optical element)

23, 24     Area sensor (light detection unit)
32         Analysis unit
100       Sample
100a      Substrate
100b      Film

**Claims**

1. A film thickness measuring apparatus for measuring a film thickness of an object having a film formed on a substrate, the film thickness measuring apparatus comprising:

   a light irradiation unit configured to irradiate the object with each of first light having a first wavelength and second light having a second wavelength different from the first wavelength;
   an optical element having transmittance and reflectance changing according to a wavelength in a predetermined wavelength range, the optical element configured to transmit and reflect the first light and the second light from the object to separate the first light and the second light;
   a light detection unit configured to detect the first light that has been reflected by the optical element and the first light that has passed through the optical element to output a first signal, and configured to detect the second light that has been reflected by the optical element and the second light that has passed through the optical element to output a second signal; and
   an analysis unit configured to derive a first wavelength centroid based on the first signal and derive a second wavelength centroid based on the second signal, wherein
   the analysis unit includes
   deriving at least one first film thickness candidate based on relationship information between the film thickness and a wavelength centroid of the object at the first wavelength, and the first wavelength centroid,
   deriving at least one second film thickness candidate based on relationship information between the film thickness and a wavelength centroid of the object at the second wavelength, and the second wavelength centroid, and
   deriving the film thickness of the object based on the first film thickness candidate and the second film thickness candidate.

2. The film thickness measuring apparatus according to claim 1, wherein the light irradiation unit further irradiates the object with third light having a third wavelength different from the first wavelength and the second wavelength,

   the optical element transmits and reflects the third light from the object to further separate the third light,
   the light detection unit further detects the third light that has been reflected by the optical element and the third light that has passed through the optical element to output a third signal,
   the analysis unit
   further derives a third wavelength centroid based on the third signal, and further derives at least one third film thickness candidate based on relationship information between the film thickness and a wavelength centroid of the object at the third wavelength, and the third wavelength centroid, and
   derives the film thickness of the object based on the first film thickness candidate, the second film thickness candidate, and the third film thickness candidate.

3. The film thickness measuring apparatus according to claim 1, wherein the analysis unit sets, in advance, an expected film thickness range from a designed film thickness value, and derives the first film thickness candidate and the second film thickness candidate only from within the expected film thickness range.

4. The film thickness measuring apparatus according to any one of claims 1 to 3, wherein the light irradiation unit

   includes a light source configured to emit monochromatic light of three or more wavelengths, and
   irradiates the object with the first light configured by simultaneously emitting monochromatic light of two wavelengths among the monochromatic light of three or more wavelengths.

5. The film thickness measuring apparatus according to claim 4, wherein the monochromatic light of two wavelengths is light of a red wavelength and light of a blue wavelength.

6. A film thickness measuring method executed by a film thickness measuring apparatus for measuring a film thickness of an object having a film formed on a substrate, the film thickness measuring method comprising:

a first irradiation step of irradiating the object with first light having a first wavelength;

a first separation step of using an optical element having transmittance and reflectance changing according to a wavelength in a predetermined wavelength range to transmit and reflect the first light from the object;

a first light detection step of detecting the first light that has been reflected by the optical element and the first light that has passed through the optical element to output a first signal;

a first calculation step of deriving a first wavelength centroid based on the first signal and deriving at least one first film thickness candidate based on relationship information between the film thickness and a wavelength centroid of the object at the first wavelength, and the first wavelength centroid;

a second irradiation step of irradiating the object with second light having a second wavelength different from the first wavelength;

a second separation step of using the optical element to transmit and reflect the second light from the object;

a second light detection step of detecting the second light that has been reflected by the optical element and the second light that has passed through the optical element to output a second signal;

a second calculation step of deriving a second wavelength centroid based on the second signal and deriving at least one second film thickness candidate based on relationship information between the film thickness and a wavelength centroid of the object at the second wavelength, and the second wavelength centroid; and

an analysis step of deriving the film thickness of the object based on said at least one first film thickness candidate determined in the first calculation step and said at least one second film thickness candidate determined in the second calculation step.

7.  The film thickness measuring method according to claim 6, further comprising a third irradiation step of further irradiating the object with third light having a third wavelength different from the first wavelength and the second wavelength,

a third separation step of transmitting and reflecting the third light from the object to further separate the third light,

a third light detection step of further detecting the third light that has been reflected by the optical element and the third light that has passed through the optical element to output a third signal, and

a third calculation step of further deriving a third wavelength centroid based on the third signal, and further deriving at least one third film thickness candidate based on relationship information between the film thickness and a wavelength centroid of the object at the third wavelength, and the third wavelength centroid, wherein

in the analysis step, the film thickness of the object is derived based on the first film thickness candidate, the second film thickness candidate, and the third film thickness candidate.

8.  The film thickness measuring method according to claim 6, wherein, in the analysis step, an expected film thickness range is set from a designed film thickness value in advance, and the first film thickness candidate and the second film thickness candidate are derived only from within the expected film thickness range.

9.  The film thickness measuring apparatus according to any one of claims 6 to 8, wherein, in the first irradiation step, the object is irradiated with the first light configured by simultaneously emitting monochromatic light of two wavelengths among monochromatic light of three or more wavelengths emitted from a light source configured to emit the monochromatic light of three or more wavelengths.

10. The film thickness measuring method according to claim 9, wherein the monochromatic light of two wavelengths is light of a red wavelength and light of a blue wavelength.

*Fig.1*

EP 4 603 792 A1

# Fig.2

*Fig.3*

# Fig.4

# Fig.5

TRANSMITTANCE,
SPECTRAL
LUMINANCE

X4

X1

λ1

λ2

WAVELENGTH

**Fig.6**

TRANSMITTANCE 100%

X4

REFLECTED LIGHT

TRANSMITTED LIGHT

I'R  I'R  I'R

I'T

I'T

I'T

λ1  λ0  λ2  WAVELENGTH

EP 4 603 792 A1

# Fig.7

**Legend:**
- —·— 820nm THICK
- ----- 830nm THICK
- —— 840nm THICK

THINNER ←→ THICKER

REFLECTANCE (%)

WAVELENGTH (nm)

*Fig.8*

FILM THICKNESS [nm]

# Fig.9

EP 4 603 792 A1

# Fig.10

(a)

**SYSTEM SPECTRAL CHARACTERISTIC**

Legend:
- ......... TRANSMISSION RED/BLUE
- ········· REFLECTION RED/BLUE
- —··— TRANSMISSION GREEN/BLUE
- —·— REFLECTION GREEN/BLUE
- —— TRANSMISSION RED/GREEN
- — REFLECTION RED/GREEN

(b)

Legend:
- – – – RED/BLUE
- —·— GREEN/BLUE
- —— RED/GREEN

# Fig.11

(a)

## SYSTEM SPECTRAL CHARACTERISTIC

Legend:
- ······ TRANSMISSION NO FILTER
- ---- REFLECTION NO FILTER
- —·— TRANSMISSION LONG-PASS FILTER
- —·— REFLECTION LONG-PASS FILTER
- —— TRANSMISSION SHORT-PASS FILTER
- —— REFLECTION SHORT-PASS FILTER

(b)

Legend:
- ---- NO FILTER
- —·— LONG-PASS FILTER
- —— SHORT-PASS FILTER

## Fig.12

START

| | |
|---|---|
| SET FILM THICKNESS SEARCH BLOCK | S1 |

| | |
|---|---|
| LIMIT FILM THICKNESS SEARCH BLOCK | S2 |

| | |
|---|---|
| DERIVE FILM THICKNESS CANDIDATES FOR EACH SEARCH BLOCK | S3 |

| | |
|---|---|
| SELECT ALL COMBINATIONS OF FILM THICKNESS CANDIDATES | S4 |

| | |
|---|---|
| SELECT OPTIMUM COMBINATION | S5 |

END

# Fig.13

(a)

THE NUMBER OF
BLOCKS: 11

(b)

THE NUMBER OF
BLOCKS: 13

(c)

THE NUMBER OF
BLOCKS: 10

## Fig.14

WAVELENGTH
CENTROID

MEASURED
VALUE

FILM THICKNESS
CANDIDATE 1

FILM THICKNESS
CANDIDATE 2

FILM THICKNESS
CANDIDATE 3

FILM THICKNESS
CANDIDATE 4

FILM
THICKNESS

EP 4 603 792 A1

# Fig.15

EP 4 603 792 A1

Fig.16

WAVELENGTH
CENTROID

WAVELENGTH CENTROID
MEASURED VALUE FOR
WAVELENGTH PATTERN 1

WAVELENGTH CENTROID
MEASURED VALUE FOR
WAVELENGTH PATTERN 2

WAVELENGTH CENTROID
MEASURED VALUE FOR
WAVELENGTH PATTERN 3

602    601    603

FILM THICKNESS CANDIDATE 3
(703)

FILM THICKNESS CANDIDATE 2
(702)

FILM THICKNESS CANDIDATE 1
(701)

FILM THICKNESS CANDIDATE 4
(704)

FILM THICKNESS CANDIDATE 5
(705)

FILM
THICKNESS

EP 4 603 792 A1

Fig.17

# Fig.18

FILM THICKNESS

COMBINATION 1

COMBINATION 2

COMBINATION 3

COMBINATION 4

701
705
703

704 705
701

702
705
703

702
705
704

SMALLEST STANDARD DEVIATION VALUE

FINAL FILM THICKNESS VALUE

EP 4 603 792 A1

**Fig.19**

(a)

(b) CORRECT

(c) MULTI-WAVELENGTH ANALYSIS RESULT

Fig.20

# Fig.21

(a)       (b)       (c)       (d)

RED/BLUE     GREEN/BLUE     RED/GREEN     RESULT OF FILM THICKNESS MAPPING (CORRECT)

## INTERNATIONAL SEARCH REPORT

| International application No. |
|---|
| **PCT/JP2023/038333** |

| A. | CLASSIFICATION OF SUBJECT MATTER |
|---|---|

*G01B 11/06*(2006.01)i
FI: G01B11/06 H

According to International Patent Classification (IPC) or to both national classification and IPC

| B. | FIELDS SEARCHED |
|---|---|

Minimum documentation searched (classification system followed by classification symbols)

G01B11/06

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | WO 2021/161986 A1 (HAMAMATSU PHOTONICS KK) 19 August 2021 (2021-08-19) paragraphs [0017]-[0020], [0029] | 1-10 |
| A | JP 2005-43371 A (KLA-TENCOR TECHNOLOGIES CORPORATION) 17 February 2005 (2005-02-17) entire text, all drawings | 1-10 |
| A | JP 10-47926 A (DAINIPPON SCREEN MFG. CO., LTD.) 20 February 1998 (1998-02-20) entire text, all drawings | 1-10 |
| A | JP 49-13251 A (HITACHI, LTD.) 05 February 1974 (1974-02-05) entire text, all drawings | 1-10 |

☐ Further documents are listed in the continuation of Box C.  ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **24 November 2023** | **05 December 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/038333**

| Patent document cited in search report | | | Publication date (day/month/year) | Patent family member(s) | | | Publication date (day/month/year) |
|---|---|---|---|---|---|---|---|
| WO | 2021/161986 | A1 | 19 August 2021 | US | 2023/0058064 | A1 | |
| | | | | paragraphs [0029]-[0032], [0041] | | | |
| | | | | EP | 4067843 | A1 | |
| | | | | CN | 115104000 | A | |
| | | | | KR | 10-2022-0137615 | A | |
| | | | | TW | 202140992 | A | |
| JP | 2005-43371 | A | 17 February 2005 | US | 2005/0018183 | A1 | |
| | | | | entire text, all drawings | | | |
| JP | 10-47926 | A | 20 February 1998 | (Family: none) | | | |
| JP | 49-13251 | A | 05 February 1974 | (Family: none) | | | |

Form PCT/ISA/210 (patent family annex) (January 2015)

**REFERENCES CITED IN THE DESCRIPTION**

**Patent documents cited in the description**

- WO 2021161986 A